# EUROPEAN PATENT APPLICATION

(11) **EP 4 729 901 A1**
(43) Date of publication of application: **22.04.2026**
(21) Application number: 25190447.0
(22) Date of filing: 18.07.2025
(51) Int. Cl.: G01K 1/024, G01K 1/143

(54) **TEMPERATURE MEASUREMENT WAFER AND SUBSTRATE PROCESSING SYSTEM USING THE SAME**

(30) Priority: 12.09.2024 JP 2024158153
(71) Applicant: SCREEN Holdings Co., Ltd., Kyoto-shi, Kyoto 602-8585 (JP)
(72) Inventor: NISHI, Koji, Kyoto, 602-8585 (JP); INAGAKI, Yukihiko, Kyoto, 602-8585 (JP)
(74) Representative: Kilian Kilian & Partner mbB

(57) **Abstract**

A temperature measurement wafer (1) includes a temperature sensor (3), a transmission unit (8), and a battery substrate (7). The transmission unit (8) wirelessly transmits temperature data of a temperature measurement subject measured by the temperature sensor (3) to the temperature measurement wafer (1). That is, the temperature measurement wafer (1) wirelessly transmits information to the outside, a decrease in operation efficiency caused by a communication wire can be avoided. The battery substrate (7) supplies power to each of the temperature sensor (3) and the transmission unit (8) using an all-solid-state secondary battery (21). Using the all-solid-state secondary battery (21) makes it possible to operate the temperature measurement wafer (1) without deteriorating its performance even under a higher temperature condition. Thus, the temperature measurement wafer (1) can be used under a higher temperature condition while improving the operation efficiency of the temperature measurement wafer (1).

## Description

### Technical Field

The present invention relates to a temperature measurement wafer for measuring a temperature of a heating plate, and a substrate processing system using the temperature measurement wafer.

### Background Art

A conventional substrate processing apparatus includes a plurality of thermal processing units. Each of the plurality of thermal processing units includes a heating plate for placing a substrate to perform thermal processing. **In** the heating plate, in-plane uniformity of temperature is strictly required. Thus, to individually adjust the individual differences of the heating plates, it is necessary to measure the temperature characteristic of each of the heating plates and appropriately control the temperature of the heating plate particularly at the time of start-up and periodic maintenance of the apparatus.

As a method for measuring the temperature characteristic of a heating plate, a method is used in which a temperature measurement wafer including a temperature sensor is placed on the heating plate, and the temperature of the heating plate is measured every predetermined time. Examples of the type of a conventionally used temperature measurement wafer include a wired temperature measurement wafer using a wire and a wireless temperature measurement wafer not using a wire.

The wired temperature measurement wafer includes a sensor substrate including a temperature sensor and a wireless communication substrate connected to the sensor substrate via a communication wire (See, for example, JP 2021-081264 A). The wireless communication substrate includes a battery and a wireless communication circuit. When the wired temperature measurement wafer is used, the sensor substrate is conveyed so as to be separated from the wireless communication substrate, and the sensor substrate is placed on a heating plate. Then, the temperature characteristic of the heating plate is measured with the temperature sensor mounted on the sensor substrate. The measurement data is transmitted from the sensor substrate to the wireless communication substrate, and further transmitted to the outside of the temperature measurement wafer by the wireless communication circuit.

The wireless temperature measurement wafer includes a wireless wafer on which a temperature sensor, a battery, a memory, and a controller are mounted (See, for example, JP 2006-080489 A). When the wireless temperature measurement wafer is used, the wireless wafer is placed on a heating plate, and a temperature characteristic of the heating plate is measured by the temperature sensor. The measurement data acquired through the measurement is stored in the memory. After the measurement of the temperature characteristic and the storage of the measurement data are performed for a plurality of heating plates, the wireless wafer is conveyed from the heating plate into a predetermined carrier. After the wireless wafer is conveyed to the carrier, the controller reads each piece of the measurement data from the memory and transmits the measurement data to the outside of the wireless wafer.

### SUMMARY

However, the conventional example having such a configuration has the following problems. First, in a conventional wired temperature measurement wafer, it is necessary to manually perform an operation of loading and disposing the temperature measurement wafer into a substrate processing apparatus, an operation of connecting the communication wire, or the like, as an example. Thus, when a conventional wired temperature measurement wafer is used, it is difficult to fully automate the temperature measurement operation for the substrate processing apparatus, and thus it is difficult to improve the efficiency of the steps of measuring the temperature of the heating plate.

In addition, when a conventional wired temperature measurement wafer is used, there is a concern that the communication wire may be bent and disconnected, or that a conveyance error of the sensor substrate may occur because of twisting of the communication wire or the like. As an example, when the sensor substrate is conveyed so as to be separated from the wireless communication substrate, if the direction in which the communication wire extends from the wireless communication substrate is different from the direction in which the sensor substrate is conveyed, the communication wire is significantly twisted. As described above, it is difficult to improve the operation efficiency with the conventional wired temperature measurement wafer.

Next, the conventional wireless temperature measurement wafer has a problem that the upper limit of the operable temperature is low. That is, since the wireless wafer on which a battery, a memory, and a controller are mounted is placed on a heating plate, electronic devices such as the memory and the controller, and the battery are likely to have a high temperature. Thus, there is a concern that the conventional wireless temperature measurement wafer has a lower upper limit of the operable temperature than the conventional wired temperature measurement wafer.

Further, in the conventional wireless temperature measurement wafer, a lithium-ion secondary battery is typically used as the battery. The lithium-ion secondary battery significantly deteriorates its battery performance under high temperature. Thus, the operation limit temperature in the wireless temperature measurement wafer decreases.

Specifically, the conventional wired temperature measurement wafer can be used under the condition that the heating plate is heated to a high temperature condition of about 250°C. On the other hand, the upper limit of the temperature condition of the heating plate at which the conventional wireless temperature measurement wafer can be operated is limited to about 150°C. Thus, when the thermal processing is performed on the substrate with the heating plate being controlled to a temperature of 150°C to 250°C, the temperature characteristic cannot be measured using the wireless temperature measurement wafer. As described above, the conventional wireless temperature measurement wafer has a problem that the usable temperature range is narrow, and versatility is low.

The present invention has been made in view of such circumstances, and an object of the present invention is to provide a temperature measurement wafer that can be used under higher temperature conditions while improving operation efficiency, and a substrate processing system using the temperature measurement wafer.

To achieve such an object, the present invention has the following configurations.

A temperature measurement wafer according to the present invention includes:
a wafer body that can be placed on a temperature measurement subject;
a plurality of temperature sensors disposed on the wafer body;
a transmission unit capable of wirelessly transmitting temperature data detected by the temperature sensors in a state where the wafer body is placed on the temperature measurement subject; and
a battery unit that is disposed on the wafer body and includes an all-solid-state secondary battery that supplies power to each of the temperature sensors and the transmission unit.

[Operation and Effect] According to the temperature measurement wafer of the present invention, the wafer body includes temperature sensors, a transmission unit, and a battery unit. The transmission unit wirelessly transmits temperature data of the temperature measurement subject measured by each temperature sensor to the outside of the temperature measurement wafer. That is, by providing the transmission unit in the wafer body, the need of a communication wire is eliminated, and the temperature measurement wafer can be operated in a wireless manner. That is, the operation of the temperature measurement wafer in a wireless manner can avoid a decrease in the operation efficiency caused by the communication wire, and thus can improve the operation efficiency of the temperature measurement wafer.

The battery unit supplies power to each of the temperature sensors and the transmission unit using an all-solid-state secondary battery. Mounting an all-solid-state secondary battery makes it possible to operate the temperature measurement wafer without deteriorating its performance even under a higher temperature condition as compared with a conventional configuration in which an alkali ion battery or the like is mounted. Thus, it is possible to use the temperature measurement wafer under a higher temperature condition while improving the operation efficiency of the temperature measurement wafer.

The transmission unit wirelessly transmits the temperature data in a state where the wafer body is placed on the temperature measurement subject. That is, the temperature data of the temperature measurement subject measured by the temperature sensor can be transmitted in real time. Thus, in a state where the temperature measurement wafer is placed on the temperature measurement subject, a step of measuring the temperature of the temperature measurement subject, a step of acquiring temperature data of the temperature measurement subject, a step of adjusting the temperature of the temperature measurement subject based on the temperature data, and a step of measuring again the temperature of the temperature measurement subject can be executed. As a result, the operation of adjusting the temperature of the temperature measurement subject using the temperature measurement wafer can be performed more quickly and with high accuracy.

In the above-described invention, it is preferable that the battery unit includes a plurality of the all-solid-state secondary batteries, and the plurality of all-solid-state secondary batteries are disposed along a surface of the wafer body in a state of being electrically connected in series.

[Operation and Effect] According to the temperature measurement wafer of the present invention, the plurality of all-solid-state secondary batteries are electrically connected in series in the battery unit. By electrically connecting the plurality of all-solid-state secondary batteries in series, the voltage of the power supplied from the battery unit can be further improved. In addition, by connecting thin-film all-solid-state secondary batteries with weak power in series, necessary power can be secured while the height of the battery unit is kept small.

In the above-described invention, it is preferable that the temperature measurement wafer includes a power supply unit that supplies power to the battery unit, wherein the power supply unit includes a wireless power receiving unit capable of receiving power supplied from an outside of the temperature measurement wafer through electromagnetic induction.

[Operation and Effect] The temperature measurement wafer according to the present invention includes a wireless power receiving unit capable of receiving power supplied from the outside of the temperature measurement wafer through electromagnetic induction. With this configuration, the battery unit can be charged wirelessly. Thus, the operating time of the temperature measurement wafer can be further extended while the temperature measurement wafer is operated in a wireless manner.

In the above-described invention, it is preferable that the battery unit includes a first heat insulating sheet disposed on the wafer body, a housing unit that is disposed on the first heat insulating sheet and incorporates the all-solid-state secondary battery having a flat shape, wherein the housing unit includes a lower surface housing part, a second heat insulating sheet, the all-solid-state secondary battery having a flat shape, a third heat insulating sheet, and an upper surface housing part stacked in this order from a side closer to the first heat insulating sheet.

[Operation and Effect] According to the temperature measurement wafer of the present invention, the battery unit includes a first heat insulating sheet and a housing unit. Since the first heat insulating sheet is disposed between the housing unit and the wafer body, the temperature of the housing unit can be avoided from increasing even when the temperature of the temperature measurement wafer increases.

In the housing unit, a lower surface housing part, a second heat insulating sheet, the all-solid-state secondary battery having a flat shape, a third heat insulating sheet, and an upper surface housing part are stacked in this order from a side closer to the first heat insulating sheet. That is, the all-solid-state secondary battery having a flat shape is sandwiched and stacked between the second heat insulating sheet and the third heat insulating sheet. Thus, it is possible to more suitably prevent an increase in temperature of the all-solid-state secondary battery while reducing the thickness of the housing unit.

In the above-described invention, the battery unit and the wafer body preferably has a total thickness of 4 mm or less.

[Operation and Effect] According to the temperature measurement wafer of the present invention, the total thickness of the battery unit and the wafer body is 4 mm or less. As a result, the thickness of the temperature measurement wafer can be made smaller than the thickness of the conveyance port of the apparatus in which the temperature measurement subject is disposed. As a result, the temperature measurement wafer can be automatically conveyed to the temperature measurement subject via the conveyance port in a state where the temperature measurement wafer is held by the conveyance arm or the like. Thus, it is easier to fully automate the operation of measuring the temperature of the temperature measurement subject with the temperature measurement wafer.

Further, in the above-described invention, the transmission unit is preferably disposed on an outer peripheral part of the wafer body.

[Operation and Effect] According to the temperature measurement wafer of the present invention, the transmission unit is disposed on the outer peripheral part of the wafer body. Thus, the distance between the transmission unit and the transmission subject of the temperature data can be further shortened when the temperature data is wirelessly transmitted from the transmission unit. In addition, it is possible to avoid the presence of an obstacle of wireless communication between the transmission unit and the transmission subject. Thus, the accuracy of wireless communication with the transmission unit can be further improved.

To achieve such an object, the present invention may have the following configuration.

That is, the present invention is a substrate processing system including:
a substrate processing apparatus that performs at least thermal processing on a substrate; and
the temperature measurement wafer according to any one of claims 1 to 5,
wherein
the substrate processing apparatus includes:
   a thermal processing unit including a heating plate that is the temperature measurement subject and performs heating processing on the substrate that has been mounted;
   a standby unit including a holding unit that holds the temperature measurement wafer, the standby unit being configured to allow the temperature measurement wafer held by the holding unit to wait inside the substrate processing apparatus;
   a conveyance unit that conveys the temperature measurement wafer between the thermal processing unit and the standby unit; and
   a power feeding unit that supplies power to the battery unit of the temperature measurement wafer conveyed to the standby unit.

[Operation and Effect] According to the substrate processing system of the present invention, in the substrate processing unit including a temperature measurement wafer and a substrate processing apparatus, the substrate processing apparatus includes a thermal processing unit, a standby unit, a conveyance unit, and a power feeding unit. The conveyance unit conveys the temperature measurement wafer between the thermal processing unit and the standby unit. The thermal processing unit includes a heating plate and performs heating processing on a substrate mounted on the heating plate. The temperature measurement wafer measures the temperature characteristic of the heating plate as a temperature measurement subject.

As described above, the temperature measurement wafer includes a wafer body, temperature sensors, a transmission unit, and a battery unit. Thus, the temperature measurement wafer can be operated by a wireless method, and thus the operation efficiency of the temperature measurement wafer can be improved. In addition, since the battery unit includes the all-solid-state secondary battery, the temperature measurement wafer can be used under a higher temperature condition. The transmission unit wirelessly transmits temperature data in a state where the wafer body is placed on the heating plate. Thus, the temperature data of the heating plate measured by the temperature sensor can be wirelessly transmitted in real time. As a result, the operation of adjusting the temperature of the heating plate using the temperature measurement wafer can be performed more quickly and with high accuracy.

The substrate processing apparatus includes a standby unit and a power feeding unit. The standby unit includes a holding unit that holds the temperature measurement wafer, and the standby unit allows the temperature measurement wafer held by the holding unit to wait inside the substrate processing apparatus. The power feeding unit supplies power to the battery unit conveyed to the standby unit. With this configuration, it is not necessary to unload the temperature measurement wafer from the substrate processing apparatus for the purpose of charging power to the battery unit. That is, even when the power of the battery unit has decreases while the temperature of the heating plate is being measured, the temperature measurement wafer is conveyed from the thermal processing unit to the standby unit, and thus the battery unit can be charged by the power feeding unit, and the temperature measurement wafer can be conveyed again to the thermal processing unit to measure the temperature. Thus, the time during which the temperature measurement wafer can be continuously operated inside the substrate processing apparatus can be further extended, and thus the operation efficiency of the temperature measurement wafer can be further improved.

In the above-described invention, it is preferable that the substrate processing system includes a receiving unit that is disposed outside the thermal processing unit and receives the temperature data wirelessly transmitted from the transmission unit.

[Operation and Effect] According to the substrate processing system of the present invention, the receiving unit receives temperature data wirelessly transmitted from the transmission unit of the temperature measurement wafer. Since the substrate processing apparatus includes the receiving unit, real-time wireless communication of temperature data can be performed inside the substrate processing apparatus in a state where the temperature measurement wafer is mounted on the heating plate. As a result, the wireless communication of the temperature data of the heating plate can be performed more quickly and accurately.

In the above-described invention, it is preferable that the substrate processing system includes a rotation mechanism that rotates the temperature measurement wafer conveyed to the standby unit to cause the transmission unit to face the receiving unit when the temperature measurement wafer is mounted on the heating plate.

[Operation and Effect] The substrate processing system according to the present invention includes a rotation mechanism that rotates the temperature measurement wafer conveyed to the standby unit. When the temperature measurement wafer is mounted on the heating plate, the rotation mechanism rotates the temperature measurement wafer such that the transmission unit faces the receiving unit. With the rotation mechanism rotating the temperature measurement wafer, the distance between the transmission unit and the receiving unit can be further shortened when the temperature data is wirelessly transmitted in a state where the temperature measurement wafer is mounted on the heating plate. In addition, it is possible to avoid the presence of an obstacle between the transmission unit and the receiving unit. Thus, the accuracy of wireless communication with the transmission unit can be further improved.

In the above-described invention, it is preferable that the temperature measurement wafer includes a battery temperature detection unit that detects a temperature of the battery unit,
the transmission unit is configured to wirelessly transmit temperature data of the battery unit detected by the battery temperature detection unit, and
the substrate processing apparatus includes:
   a wafer cooling control unit that performs control to cool the temperature measurement wafer when the temperature data of the battery unit has a value equal to or more than a predetermined operation threshold; and
   a notification unit that notifies that the temperature of the battery unit has a value equal to or more than the operation threshold.

[Operation and Effect] According to the substrate processing system of the present invention, the temperature data of the battery unit detected by the battery temperature detection unit is transmitted to the outside of the temperature measurement wafer by the transmission unit. The substrate processing apparatus includes a wafer cooling control unit and a notification unit. When the temperature data of the battery unit has a value equal to or more than a predetermined operation threshold, the wafer cooling control unit performs control to cool the temperature measurement wafer, and the notification unit notifies that the temperature of the battery unit has a value equal to or more than the operation threshold.

With the wafer cooling control unit performing control to cool the temperature measurement wafer, it is possible to quickly and reliably avoid a situation in which the performance of the temperature measurement wafer is deteriorated due to an excessive increase in the temperature of the battery unit. In addition, with the notification unit notifying that the temperature of the battery unit has a value equal to or more than the operation threshold, the operator using the substrate processing system can quickly grasp that the temperature of the battery unit has a value equal to or more than the operation threshold. Thus, the operator can quickly perform an operation for avoiding an increase in temperature of the temperature measurement wafer. As a result, it is possible to more reliably avoid a situation in which the performance of the temperature measurement wafer is deteriorated due to an excessive increase in the temperature of the battery unit.

In the above-described invention, it is preferable that the substrate processing apparatus includes a temperature control unit that adjusts a temperature of the heating plate based on the temperature data of the heating plate transmitted from the transmission unit, and the temperature control unit adjusts the temperature of the heating plate based on the temperature data of the heating plate in a state where the temperature measurement wafer is placed on the heating plate.

[Operation and Effect] According to a substrate processing system of the present invention, the substrate processing apparatus includes a temperature control unit. The temperature control unit adjusts the temperature of the heating plate based on the temperature data of the heating plate transmitted from the transmission unit of the temperature measurement wafer. Then, the temperature control unit adjusts the temperature of the heating plate based on the temperature data of the heating plate in a state where the temperature measurement wafer is placed on the heating plate.

In this case, in a state where the temperature measurement wafer is placed on the heating plate three steps of a step of measuring temperature data of the heating plate, a step of transmitting the temperature data of the heating plate from the temperature measurement wafer to the substrate processing apparatus, and a step of adjusting the temperature of the heating plate on which the temperature measurement wafer is placed with the temperature control unit based on the temperature data can be continuously executed.

Since these steps are continuously executed in a state where the temperature measurement wafer is placed on the heating plate, it is possible to quickly execute the step of measuring again the temperature data of the heating plate using the temperature measurement wafer that continues to be placed on the heating plate after the temperature control unit adjusts the temperature of the heating plate. That is, it is possible to quickly check whether the temperature of the heating plate is accurately adjusted by the temperature control unit. As a result, with the configuration in which these steps can be repeatedly executed in a state where the temperature measurement wafer is placed on the heating plate, the temperature of the heating plate can be quickly and accurately adjusted.

To achieve such an object, the present invention may have the following configuration.

That is, the present invention is a substrate processing system including a substrate processing apparatus that performs at least thermal processing on a substrate,
wherein
the substrate processing apparatus includes:
a thermal processing unit including a heating plate that is the temperature measurement subject and performs thermal processing on the substrate that has been mounted;
a standby unit including a holding unit that holds the temperature measurement wafer according to any one of claims 1 to 6, the standby unit being configured to allow the temperature measurement wafer held by the holding unit to wait inside the substrate processing apparatus;
a conveyance unit that conveys the temperature measurement wafer between the thermal processing unit and the standby unit; and
a power feeding unit that supplies power to the battery unit of the temperature measurement wafer conveyed to the standby unit.

[Operation and Effect] According to the substrate processing system of the present invention, in the substrate processing unit including the substrate processing apparatus, the substrate processing apparatus includes a thermal processing unit, a standby unit, a conveyance unit, a power feeding unit, and a holding unit. The conveyance unit conveys the temperature measurement wafer between the thermal processing unit and the standby unit. The thermal processing unit includes a heating plate and performs heating processing on a substrate mounted on the heating plate. The temperature measurement wafer measures the temperature characteristic of the heating plate as a temperature measurement subject.

The holding unit holds the temperature measurement wafer. As described above, the temperature measurement wafer includes a wafer body, temperature sensors, a transmission unit, and a battery unit. Thus, the temperature measurement wafer can be operated by a wireless method, and thus the operation efficiency of the temperature measurement wafer can be improved. In addition, since the battery unit includes the all-solid-state secondary battery, the temperature measurement wafer can be used under a higher temperature condition. The transmission unit wirelessly transmits temperature data in a state where the wafer body is placed on the heating plate. Thus, the temperature data of the heating plate measured by the temperature sensor can be wirelessly transmitted in real time. As a result, the operation of adjusting the temperature of the heating plate using the temperature measurement wafer can be performed more quickly and with high accuracy.

The substrate processing apparatus includes a standby unit and a power feeding unit. The standby unit includes a holding unit that holds the temperature measurement wafer, and the standby unit allows the temperature measurement wafer held by the holding unit to wait inside the substrate processing apparatus. The power feeding unit supplies power to the battery unit conveyed to the standby unit. With this configuration, it is not necessary to unload the temperature measurement wafer from the substrate processing apparatus for the purpose of charging power to the battery unit. That is, even when the power of the battery unit has decreases while the temperature of the heating plate is being measured, the temperature measurement wafer is conveyed from the thermal processing unit to the standby unit, and thus the battery unit can be charged by the power feeding unit, and the temperature measurement wafer can be conveyed again to the thermal processing unit to measure the temperature. Thus, the time during which the temperature measurement wafer can be continuously operated inside the substrate processing apparatus can be further extended, and thus the operation efficiency of the temperature measurement wafer can be further improved.

The temperature measurement wafer and the substrate processing system using the temperature measurement wafer according to the present invention can be used under higher temperature conditions while improving the operation efficiency.

### BRIEF DESCRIPTION OF DRAWINGS

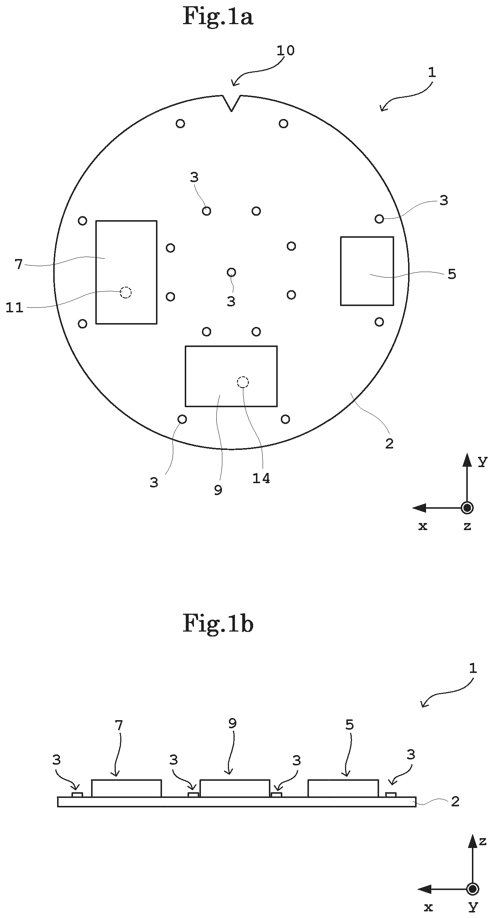

FIGS. 1A and 1B are a diagrams for describing a configuration of a temperature measurement wafer according to Example 1;
FIG. 1A is a plan view of the temperature measurement wafer, and FIG. 1B is a front view of the temperature measurement wafer;
FIG. 2 is a longitudinal sectional view of a battery substrate according to Example 1;
FIG. 3 is a functional block diagram of a substrate processing system according to Example 1;
FIG. 4 is a transverse sectional view of a substrate processing apparatus according to Example 1;
FIG. 5 is a longitudinal sectional view of the substrate processing apparatus according to Example 1;
FIGS. 6A and 6B are diagrams for describing a configuration of a substrate conveyance mechanism according to Example 1;

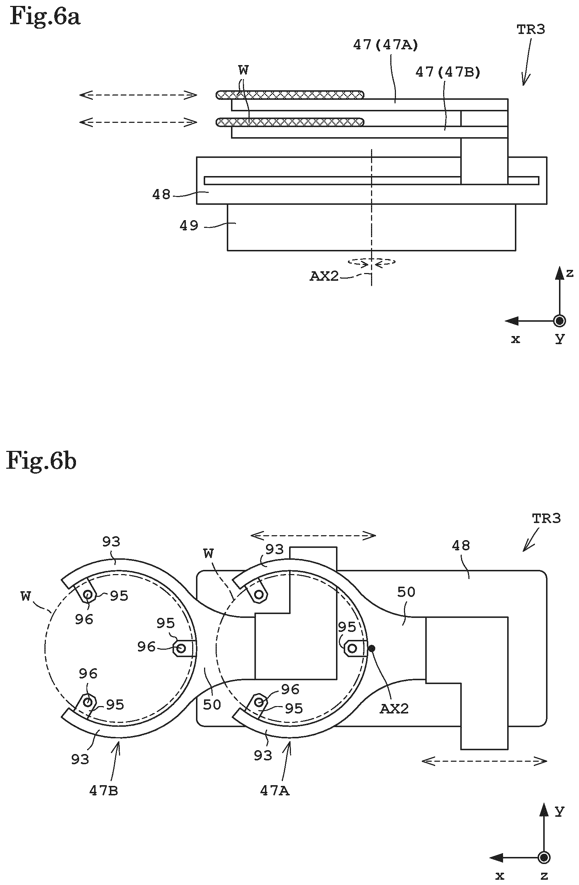

FIG. 6A is a front view of the substrate conveyance mechanism, and FIG. 6B is a plan view of the substrate conveyance mechanism;

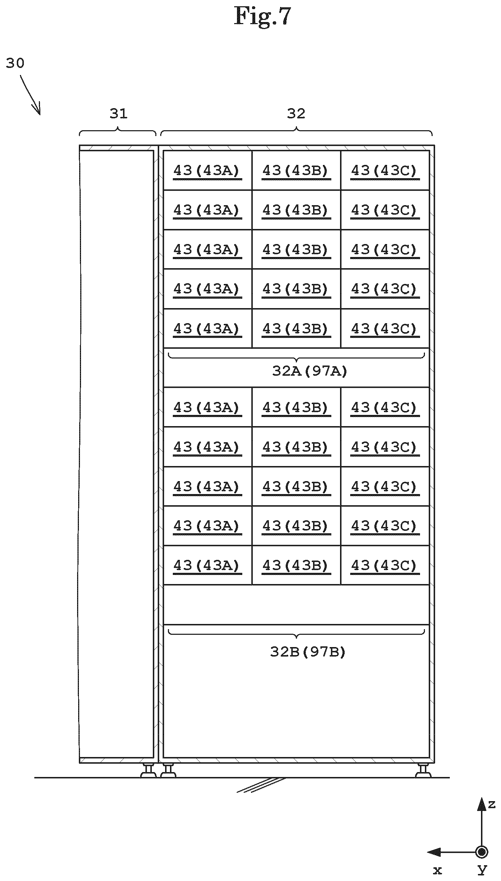

FIG. 7 is a longitudinal sectional view of the substrate processing apparatus, illustrating the disposition of thermal processing units according to Example 1;

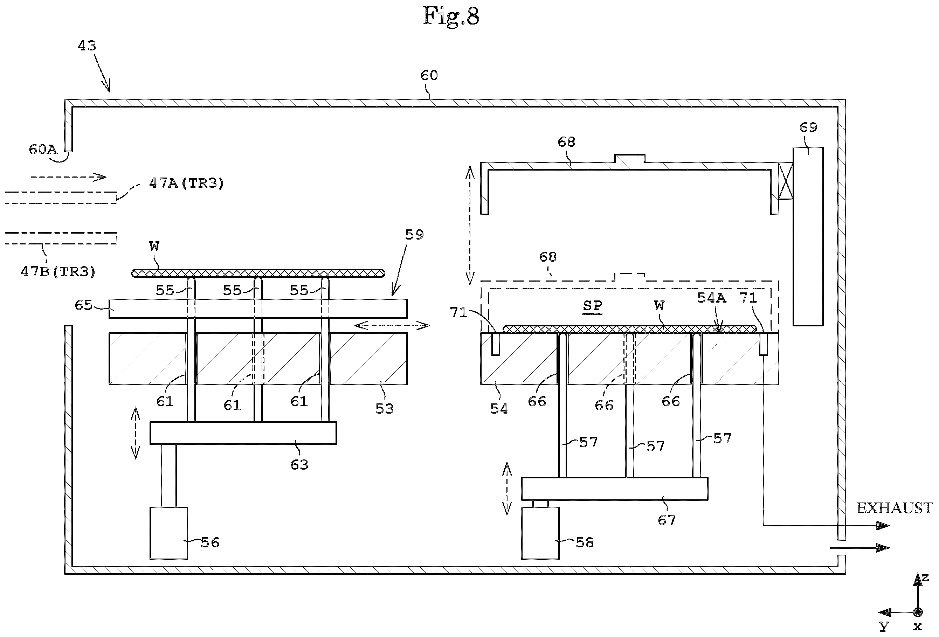

FIG. 8 is a longitudinal sectional view of a thermal processing unit according to Example 1;

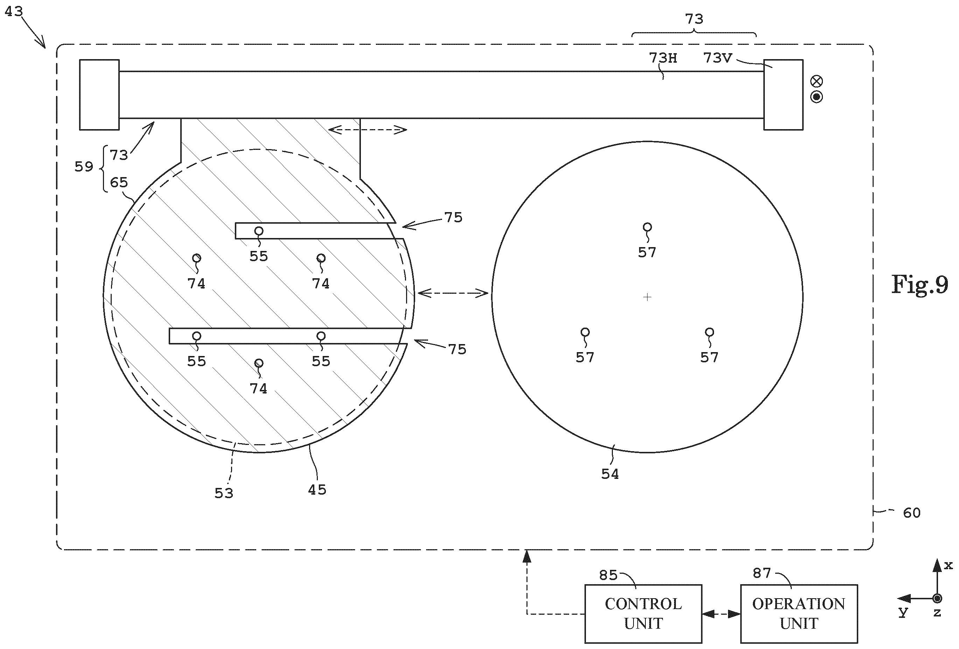

FIG. 9 is a transverse sectional view of the thermal processing unit according to Example 1;

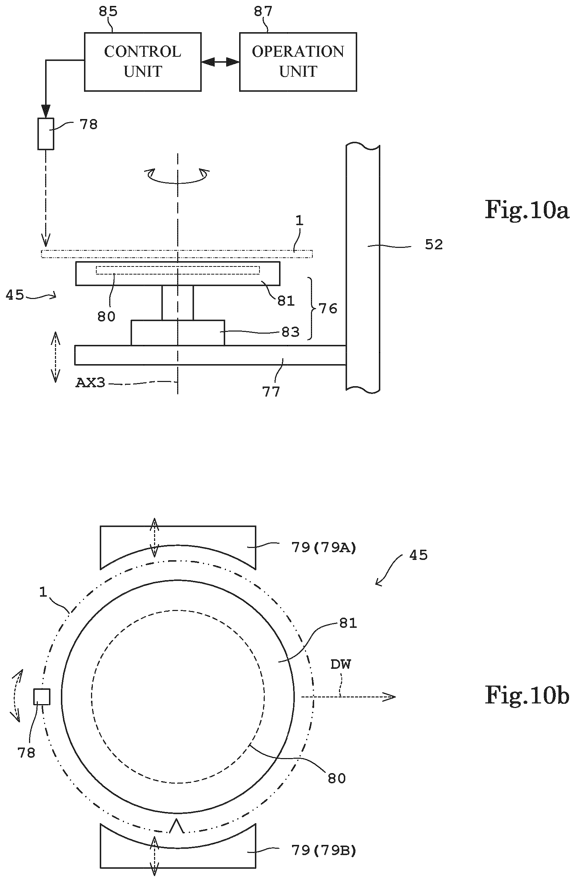

FIGS. 10A and 10B are diagrams for describing a configuration of a standby unit according to Example 1;
FIG. 10A is a front view of the standby unit, and FIG. 10B is a plan view of the standby unit;

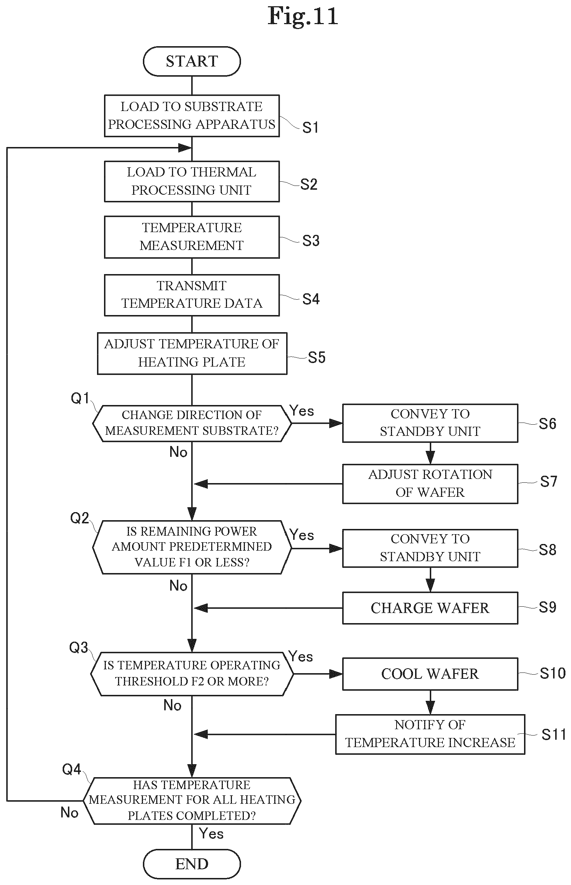

FIG. 11 is a flowchart illustrating an operation of the substrate processing system according to Example 1;

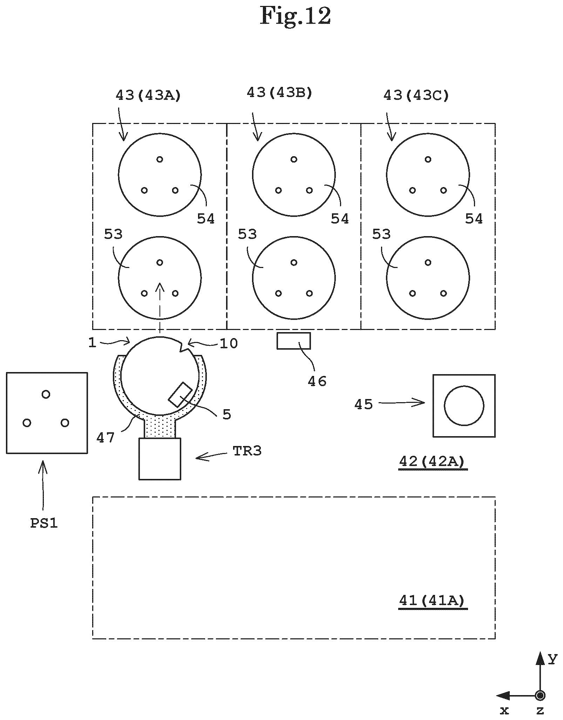

FIG. 12 is a transverse sectional view for describing step S2 according to Example 1;

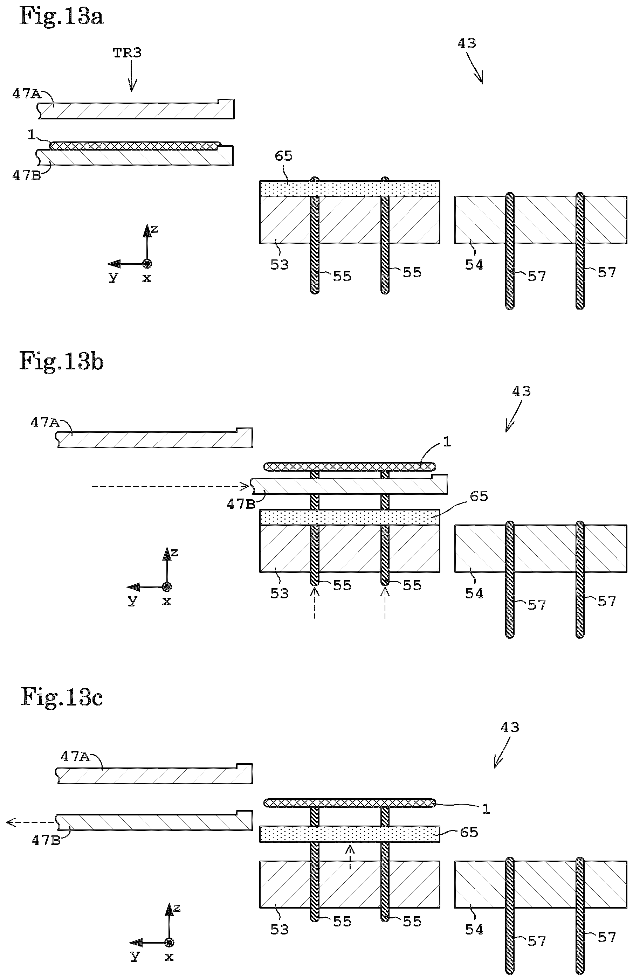

FIGS. 13A to 13C are longitudinal sectional views for describing step S3 according to Example 1;

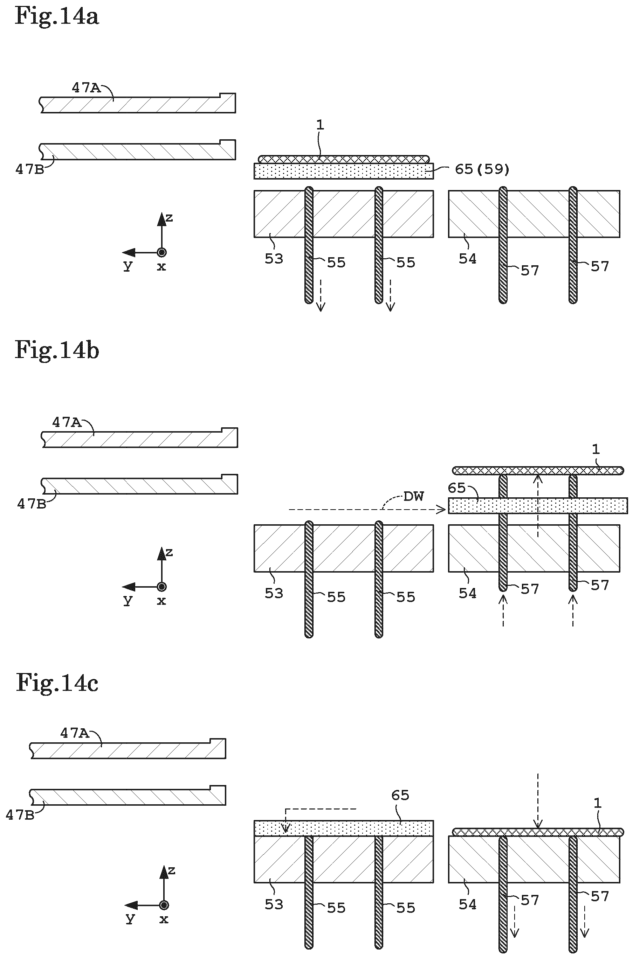

FIGS. 14A to 14C are longitudinal sectional views for describing step S3 according to Example 1;

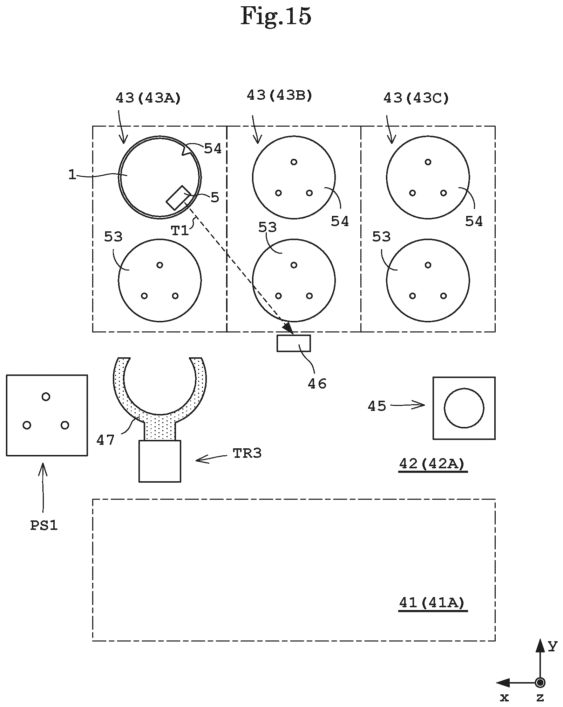

FIG. 15 is a transverse sectional view for describing step S3 according to Example 1;

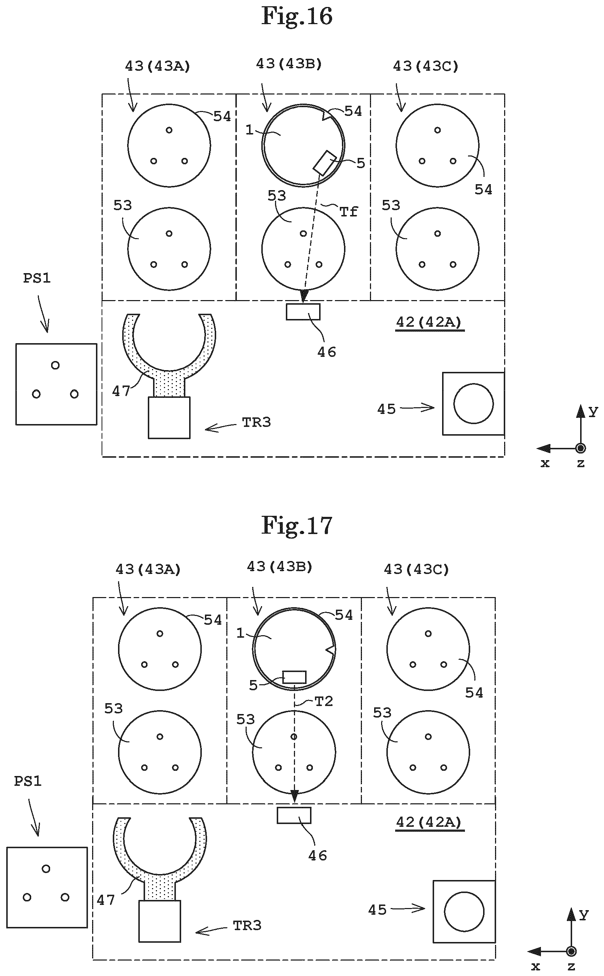

FIG. 16 is a transverse sectional view for describing step S3 according to a comparative example;
FIG. 17 is a transverse sectional view for describing step S3 according to Example 1;

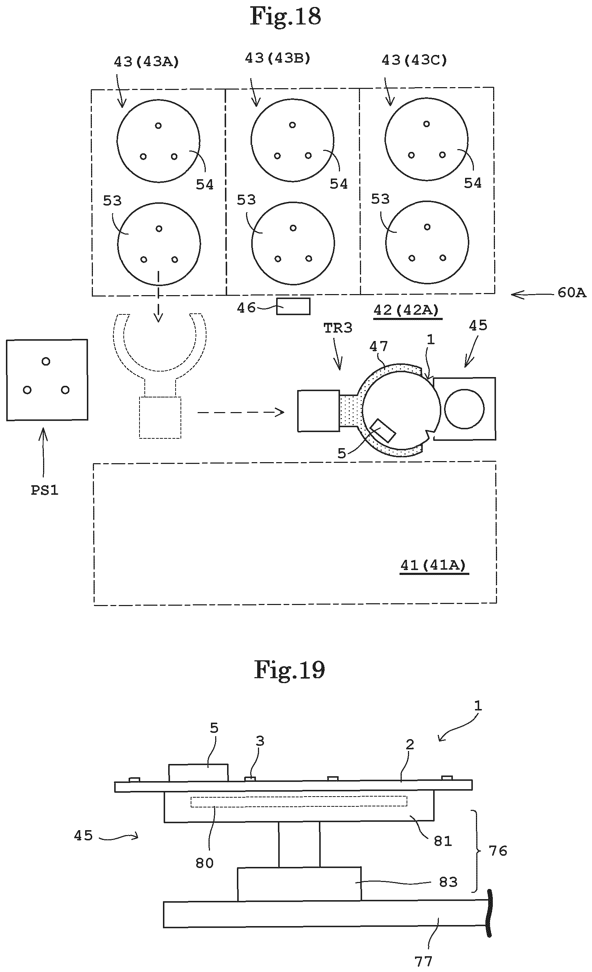

FIG. 18 is a transverse sectional view for describing step S6 according to Example 1;
FIG. 19 is a transverse sectional view for describing step S6 according to Example 1;

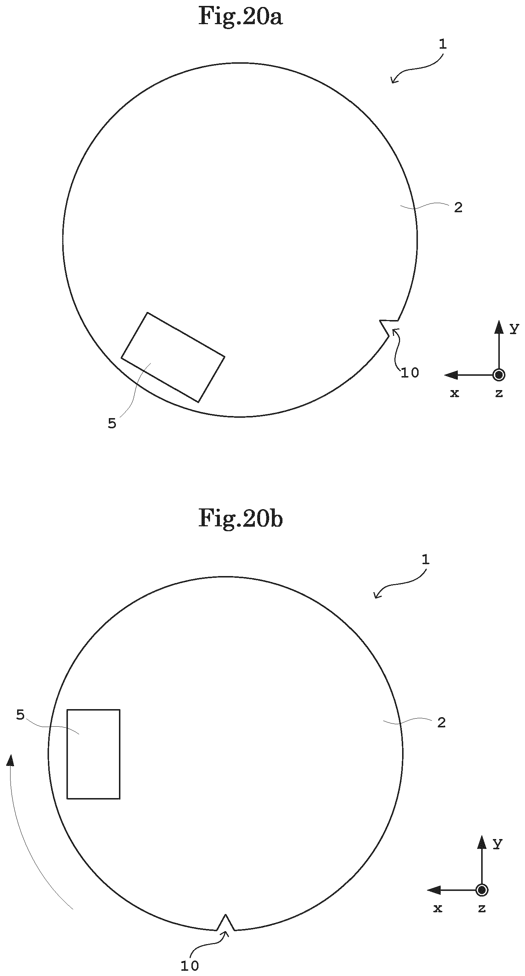

FIGS. 20A and 20B are plan views for describing step S7 according to Example 1;
FIG. 20A is a plan view illustrating a state before rotation, and FIG. 20B is a plan view illustrating a state after rotation;

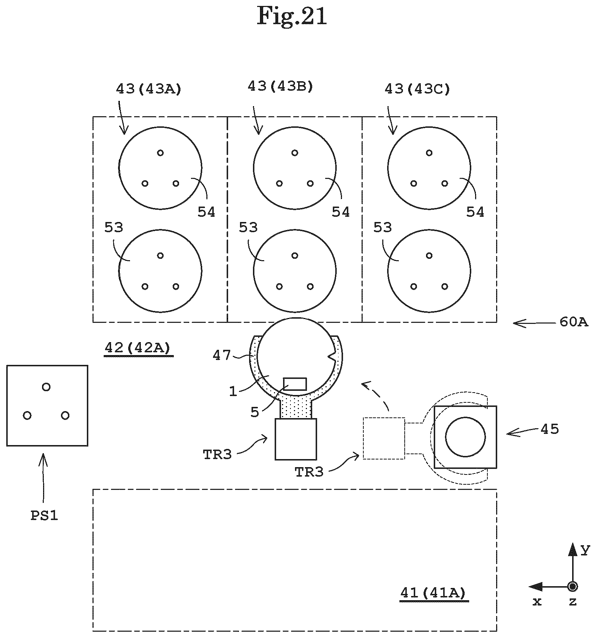

FIG. 21 is a transverse sectional view for describing step S2 according to Example 1;

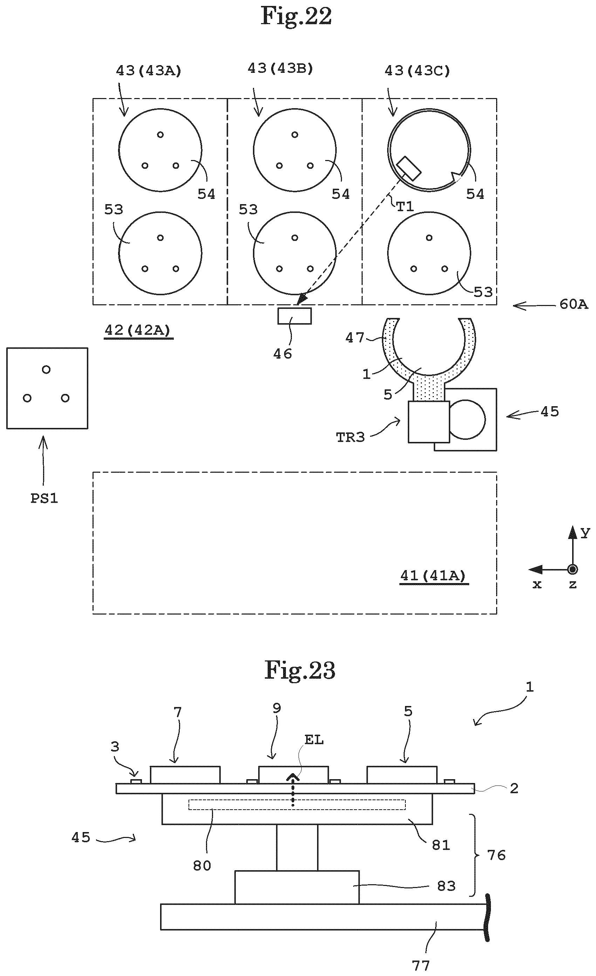

FIG. 22 is a transverse sectional view for describing step S3 according to Example 1;
FIG. 23 is a transverse sectional view for describing step S9 according to Example 1;

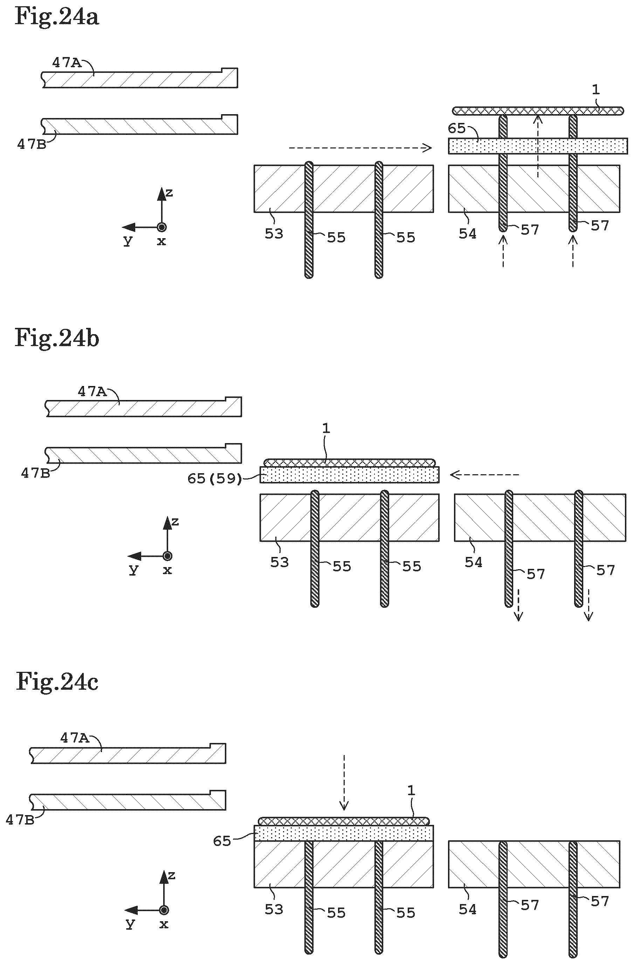

FIGS. 24A to 24C are longitudinal sectional views for describing step S10 according to Example 1;

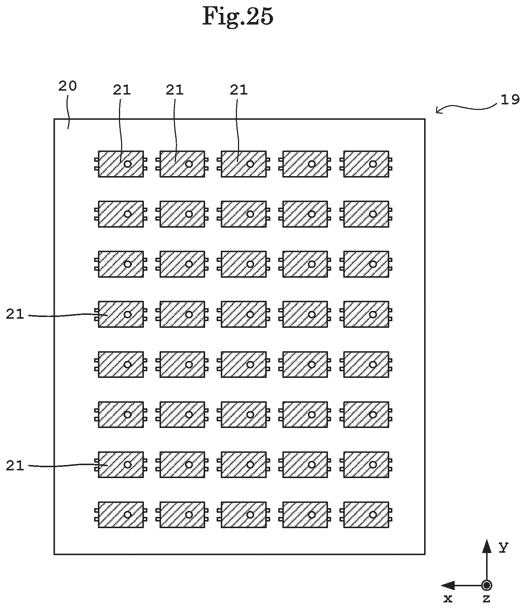

FIG. 25 is a plan view of a battery unit according to Example 1;

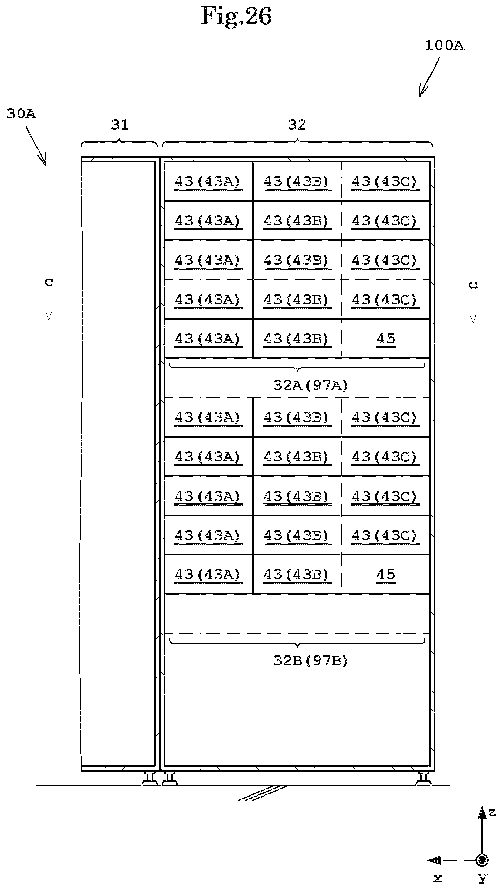

FIG. 26 is a longitudinal sectional view of the substrate processing apparatus, illustrating the disposition of thermal processing units according to Example 2;

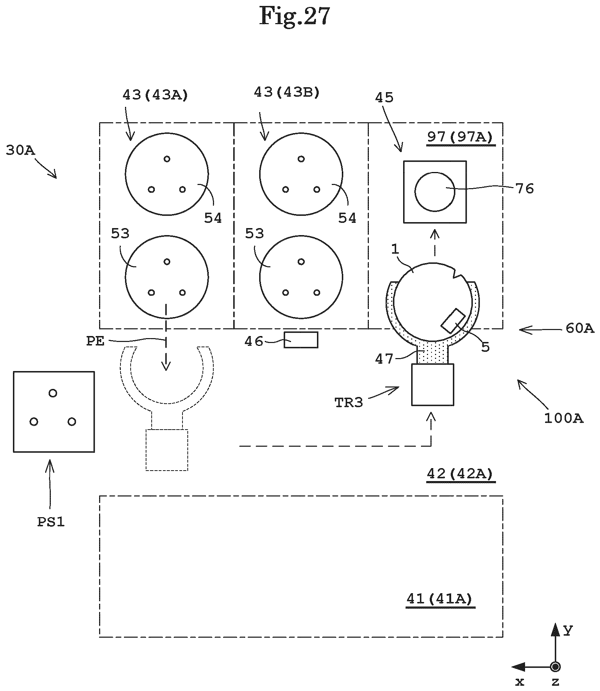

FIG. 27 is a transverse sectional view for describing step S6 according to Example 2;

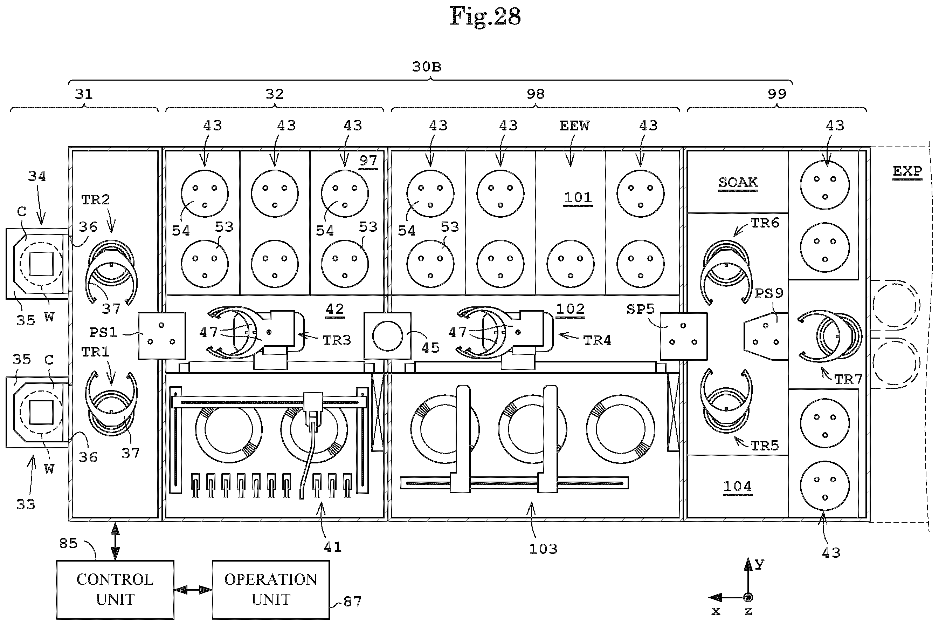

FIG. 28 is a transverse sectional view of a substrate processing apparatus according to Example 3; and

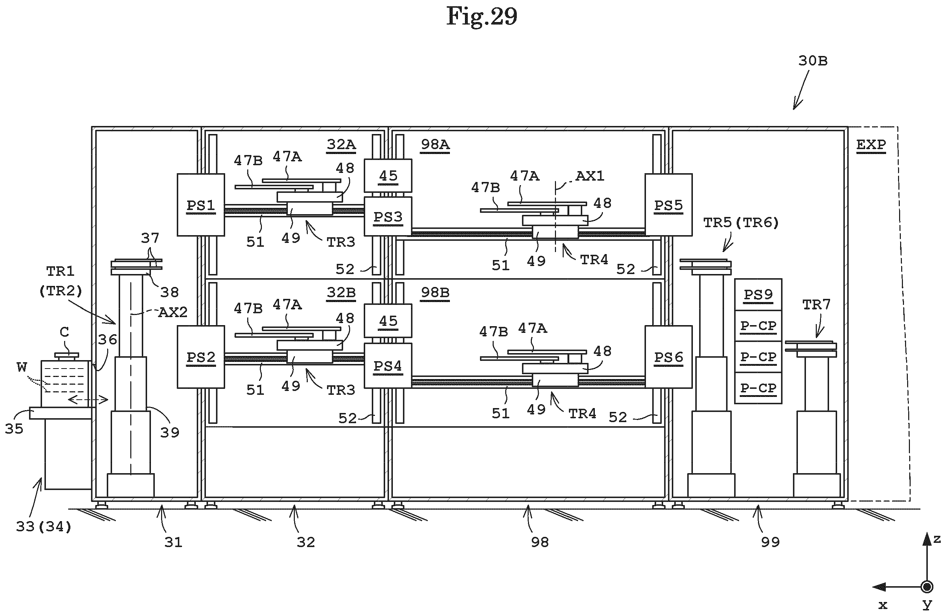

FIG. 29 is a longitudinal sectional view of the substrate processing apparatus according to Example 3.

### DETAILED DESCRIPTION

### Example 1

Hereinafter, Example 1 of the present invention will be described with reference to the drawings.

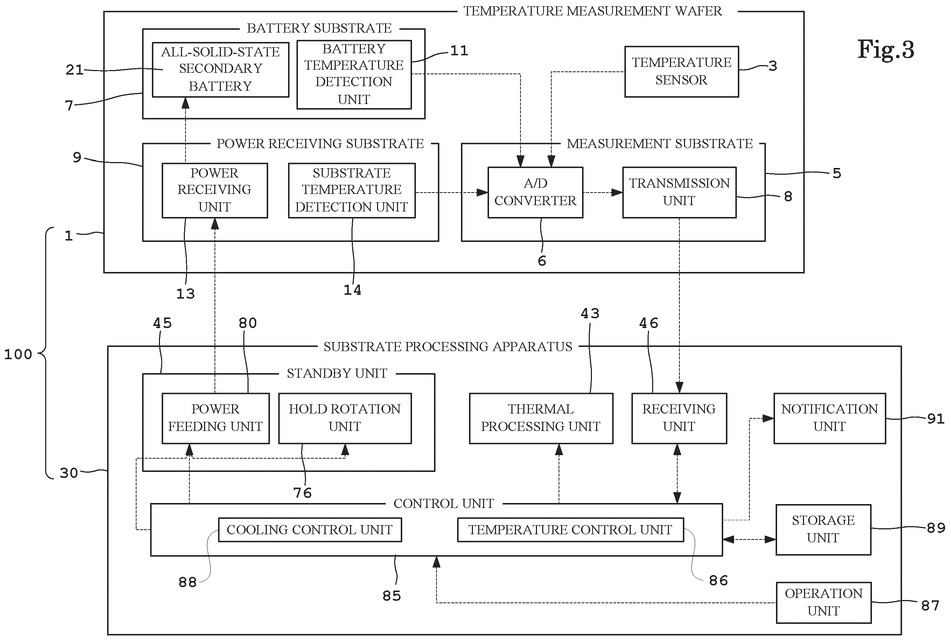

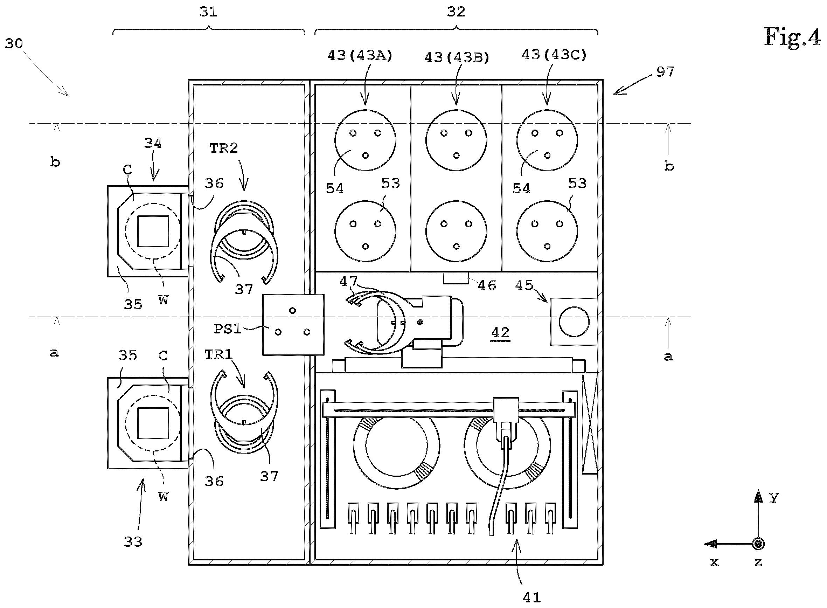

As illustrated in FIG. 3, a substrate processing system 100 according to Example 1 includes a temperature measurement wafer 1 and a substrate processing apparatus 30. The temperature measurement wafer 1 measures the temperature of a heating plate 54 (see FIG. 4) in a thermal processing unit 43 included in the substrate processing apparatus 30 as a temperature measurement subject. The substrate processing apparatus 30 performs various types of processing on a normal semiconductor wafer W (hereinafter, referred to as "wafer W"). The various types of processing include at least thermal processing.

### <Configuration of Temperature Measurement Wafer>

First, the temperature measurement wafer 1 will be described with reference to FIGS. 1A and 1B and the like. FIG. 1A is a plan view of the temperature measurement wafer 1 according to Example 1. FIG. 1B is a front view of the temperature measurement wafer 1 according to Example 1.

The temperature measurement wafer 1 includes a wafer body 2, a plurality of temperature sensors 3, a measurement substrate 5, a battery substrate 7, and a power receiving substrate 9. The wafer body 2 is formed in a disk shape. The wafer body 2 is made of, as an example, silicon or ceramic. The wafer body 2 is formed to have substantially the same diameter as the wafer W (as an example, 300 mm).

Each of the temperature sensors 3 is disposed on a surface of the wafer body 2. Each of the temperature sensors 3 measures the temperature of the wafer body 2. In FIG. 1A, for convenience of description, 17 temperature sensors 3 are provided on the wafer body 2. As an example, the plurality of temperature sensors 3 are disposed radially, concentrically, or in a form of a combination thereof on the surface of the wafer body 2. In Example 1, one temperature sensor 3 is disposed at the center of the wafer body 2, and eight temperature sensors are disposed at an outer peripheral part of the wafer body 2. Eight temperature sensors are disposed between the outer peripheral part and the central part of the wafer body 2. The plurality of temperature sensors 3 are preferably disposed evenly on the surface of the wafer body 2. Examples of the temperature sensors 3 include a thermocouple, a resistance temperature detector, and a quartz oscillator. In Example 1, the outer peripheral part of the wafer body 2 preferably corresponds to a portion outside a concentric circle of about 2/3 of the diameter of the wafer body 2.

The measurement substrate 5 performs various types of information processing such as digitization processing of data measured in the temperature measurement wafer 1, and performs communication with the outside of the temperature measurement wafer 1. The measurement substrate 5 is disposed on a part of the outer peripheral part of the wafer body 2. FIG. 1A illustrates an example in which the measurement substrate 5 is disposed on the right-end side of the outer peripheral part of the wafer body 2. As illustrated in FIG. 3, the measurement substrate 5 includes an A/D converter 6 and a transmission unit 8.

The A/D converter 6 is electrically connected to the temperature sensors 3, the transmission unit 8, and the like. The A/D converter 6 digitally converts temperature data and the like measured by the temperature sensors 3 and transmits the converted data to the transmission unit 8. The transmission unit 8 transmits information such as temperature data to the outside of the temperature measurement wafer 1. Transmission of information through the transmission unit 8 is performed in a wireless manner. That is, the temperature measurement wafer 1 is a wireless temperature measurement wafer that wirelessly communicates with the outside in real time. As the transmission unit 8, a wireless communication unit such as Bluetooth (registered trademark) or Wi-Fi (registered trademark) is used.

The battery substrate 7 supplies power to each of the temperature sensors 3 and the measurement substrate 5. The battery substrate 7 is disposed on a surface of the wafer body 2. FIG. 1A illustrates an example in which the battery substrate 7 is disposed on the left-end side of the wafer body 2. The battery substrate 7 corresponds to a battery unit in the present invention.

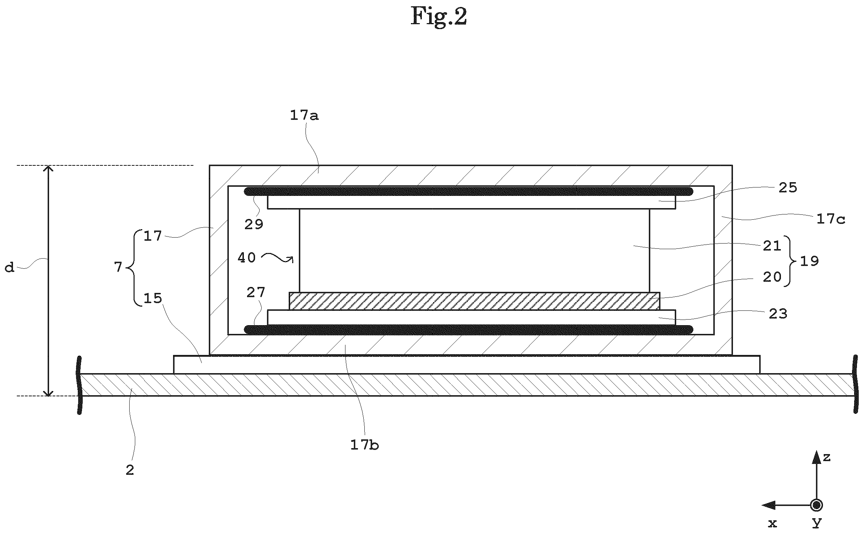

FIG. 2 is a longitudinal sectional view of the battery substrate 7 disposed on the wafer body 2. The battery substrate 7 includes a heat insulating sheet 15 and a housing 17. The heat insulating sheet 15 is disposed in contact with a surface (upper surface) of the wafer body 2. The housing 17 is disposed in contact with the surface of heat insulating sheet 15. The heat insulating sheet 15 corresponds to a first heat insulating sheet in the present invention. The housing 17 corresponds to a housing unit in the present invention.

The heat insulating sheet 15 prevents heat of the wafer body 2 from being transferred to the housing 17 and the inside of the housing 17. That is, the heat insulating sheet 15 suppresses an increase in the temperature of the housing 17 and the inside of the housing 17 caused by an increase in the temperature of the wafer body 2. As a material constituting the heat insulating sheet 15, a fiber material such as glass fiber or carbon fiber is preferably used. A silicon cloth is more preferably used as a constituent material of the heat insulating sheet 15. Using these constituent materials makes it possible to further reduce the thickness of the battery substrate 7 while improving the heat insulating property of the heat insulating sheet 15.

The housing 17 incorporates a battery unit 19 and the like. Examples of a constituent material of the housing 17 include stainless steel and metal. The internal space of the housing 17 is sealed by an upper plate 17a, a lower plate 17b, and a side plate 17c of the housing 17. The housing 17 protects the battery substrate 7 and the like incorporated in the housing. The upper plate 17a corresponds to an upper surface housing part of the present invention. The lower plate 17b corresponds to a lower surface housing part of the present invention.

The battery unit 19 includes a base substrate 20 and an all-solid-state secondary battery 21. The base substrate 20 is, as an example, a plate-like member made of silicon or the like as a constituent material. The all-solid-state secondary battery 21 is a secondary battery disposed on the upper surface of the base substrate 20. As an example, as illustrated in FIG. 25, the battery unit 19 has a configuration in which a plurality of all-solid-state secondary batteries 21 (as an example, 40 all-solid-state secondary batteries 21) are arranged in a two-dimensional matrix on the base substrate 20. As the solid electrolyte of the all-solid-state secondary battery 21, an oxide-based material such as sodium iron phosphate, a sulfide-based material such as diphosphorus pentasulfide, or the like may be appropriately used. Using the all-solid-state secondary battery 21 having no electrolytic solution for the battery substrate 7 makes it possible to suppress performance deterioration caused by high temperature of the battery substrate 7. Therefore, the operation limit temperature of the battery substrate 7 can be further improved.

As illustrated in FIG. 2, a heat insulating sheet 23 is disposed on the lower surface of the battery unit 19, and the heat insulating sheet 25 is disposed on the upper surface of the battery unit 19. That is, the heat insulating sheet 23 is in contact with the lower surface of the base substrate 20, and the heat insulating sheet 25 is in contact with the upper surface of the all-solid-state secondary battery 21. The heat insulating sheet 23 and the heat insulating sheet 25 are made of the same material as the heat insulating sheet 15. In the housing 17, the heat insulating sheet 23 and the heat insulating sheet 25 prevents heat transfer to the all-solid-state secondary battery 21. The heat insulating sheet 23 corresponds to a second heat insulating sheet in the present invention. The heat insulating sheet 25 corresponds to a third heat insulating sheet in the present invention.

As illustrated in FIG. 2, a tape 27 is attached to the lower surface of the heat insulating sheet 23, and a tape 29 is attached to the upper surface of the heat insulating sheet 25. That is, a battery stack 40 in which the tape 27, the heat insulating sheet 23, the base substrate 20, the all-solid-state secondary battery 21, the heat insulating sheet 25, and the tape 29 are stacked in this order is disposed inside the housing 17.

At least the upper surface of the tape 27 in contact with the heat insulating sheet 23 is an adhesive surface. The lower surface of the tape 27 is a flat surface. Thus, the heat insulating sheet 23 can be fixed to the battery unit 19, and the flatness of the lower surface of the battery stack 40 can be improved by attaching the tape 27 to the lower surface of the heat insulating sheet 23. The tape 27 is preferably a heat-resistant tape having a polyimide-based material such as Kapton tape (Kapton is a registered trademark). Using a heat-resistant tape as the tape 27 makes it possible to more suitably suppress the temperature increase of the all-solid-state secondary battery 21.

At least the lower surface of the tape 29 in contact with the heat insulating sheet 25 is an adhesive surface. The upper surface of the tape 29 is a flat surface. Thus, the heat insulating sheet 25 can be fixed to the battery unit 19, and the flatness of the lower surface of the battery stack 40 can be improved by attaching the tape 29 to the upper surface of the heat insulating sheet 25. The tape 29 is made of the same material as the tape 27. Using a heat-resistant tape as the tape 27 makes it possible to more suitably suppress the temperature increase of the all-solid-state secondary battery 21.

In this manner, the battery substrate 7 has a structure in which the heat insulating sheet 15, the lower plate 17b of the housing 17, the tape 27, the heat insulating sheet 23, the battery unit 19, the heat insulating sheet 25, the tape 29, and the upper plate 17a of the housing 17 are stacked in order from the side closer to the wafer body 2 in a thickness direction (z direction in FIG. 2). The thickness d of the temperature measurement wafer 1 at the portion where the battery substrate 7 is disposed is 4 mm or less. The thickness d corresponds to the sum of the thickness of the wafer body 2 and the thickness of the battery unit 7. Of the entire temperature measurement wafer 1, the thickness of a portion where the battery unit 7 is formed is the largest. That is, when the thickness d is 4 mm or less, the temperature measurement wafer 1 has a thickness of 4 mm or less over the entire temperature measurement wafer 1. By having such a stack structure in which the flat all-solid-state secondary battery 21 is sandwiched between a plurality of heat insulating sheets, the thickness of the battery substrate 7 including the all-solid-state secondary battery 21 can be further reduced while improving the heat resistance of the battery substrate 7.

As illustrated in FIG. 1 and the like, the battery substrate 7 includes a battery temperature detection unit 11. The battery temperature detection unit 11 is a temperature sensor built in the battery substrate 7. The battery temperature detection unit 11 detects the temperature of the battery substrate 7. As illustrated in FIG. 3, the battery temperature detection unit 11 is electrically connected to the measurement substrate 5. The temperature data of the battery substrate 7 detected by the battery temperature detection unit 11 is transmitted to the measurement substrate 5. The transmitted temperature data of the battery substrate 7 is digitally converted by the A/D converter 6, and can be transmitted to the outside of the temperature measurement wafer 1 by the transmission unit 8.

The power receiving substrate 9 is disposed on a surface of the wafer body 2. FIG. 1A illustrates an example in which the power receiving substrate 9 is disposed on the lower-end side of the wafer body 2. The power receiving substrate 9 is electrically connected to each of the battery substrate 7 and the measurement substrate 5. The power receiving substrate 9 includes a power receiving unit 13 and a substrate temperature detection unit 14. The power receiving unit 13 includes an integrated circuit for power reception (power receiving IC), and is configured to be able to receive power. The power receiving unit 13 receives power transmitted from the outside of the temperature measurement wafer 1 and transmits the power to the battery substrate 7. The power receiving unit 13 is configured to be able to receive external power in a wireless manner. That is, by providing the power receiving substrate 9 in the wafer body 2, the battery substrate 7 can be charged in a wireless manner. The power receiving substrate 9 corresponds to a power supply unit in the present invention. The power receiving unit 13 corresponds to a wireless power receiving unit in the present invention.

The substrate temperature detection unit 14 is a temperature sensor built in the power receiving substrate 9. The substrate temperature detection unit 14 detects the temperature of the power receiving substrate 9. As illustrated in FIG. 3, the substrate temperature detection unit 14 is electrically connected to the measurement substrate 5. Temperature data of the power receiving substrate 9 detected by the substrate temperature detection unit 14 is transmitted to the measurement substrate 5. The transmitted temperature data of the power receiving substrate 9 is digitally converted by the A/D converter 6, and can be transmitted to the outside of the temperature measurement wafer 1 by the transmission unit 8.

As illustrated in FIG. 1, a notch 10 is formed in an outer edge of the temperature measurement wafer 1. The notch 10 functions as a reference for adjusting the orientation of the measurement substrate 5 in the temperature measurement wafer 1. The depth of the notch 10 is, as an example, about 1 mm. In FIG. 1A, the notch 10 is formed on the upper side of the temperature measurement wafer 1. By appropriately rotating the temperature measurement wafer 1 with reference to the notch 10, the orientation of the measurement substrate 5 in plan view can be adjusted to a predetermined angle. The temperature measurement wafer 1 may have a configuration different from the notch 10 as long as the configuration serves as a reference for adjusting the orientation of the measurement substrate 5. That is, an orientation flat, a mark, or the like may be formed on the temperature measurement wafer 1 instead of the notch 10.

### <Configuration of Substrate Processing Apparatus>

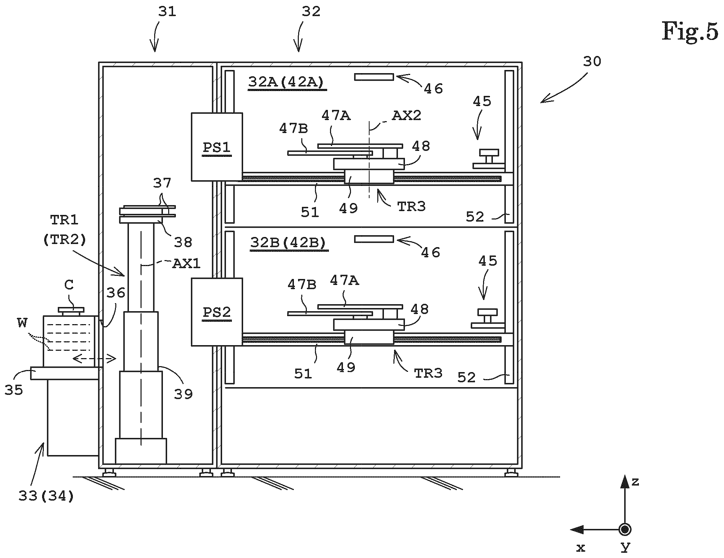

Next, the substrate processing apparatus 30 will be described with reference to FIG. 4 and the like. FIG. 4 is a transverse sectional view of the substrate processing apparatus 30 according to Example 1. FIG. 5 is a longitudinal sectional view of the substrate processing apparatus 30. FIG. 5 corresponds to a sectional view taken along arrows a-a in FIG. 4. The substrate processing apparatus 30 according to Example 1 performs coating processing and thermal processing on the wafer W. In the substrate processing apparatus 30, a right-and-left direction is defined as an x direction. A front-to-rear direction is a y direction, and an up/down direction is a z direction.

The substrate processing apparatus 30 includes an indexer block 31 and a processing block 32. The indexer block 31 includes two openers 33 and 34 and two substrate conveyance mechanisms TR1 and TR2. Each of the two openers 33 and 34 (carrier placement units) provided in the indexer block 31 places a carrier C capable of storing a plurality of wafers W. As the carrier C, for example, a front open unified pod (FOUP) is used. The carrier C is configured to be able to store the temperature measurement wafer 1 in addition to the wafer W.

Each of the openers 33 and 34 includes a stage 35 on which the carrier C is placed, an opening 36 for causing the wafer W or the temperature measurement wafer 1 to pass therethrough, a shutter member (not illustrated) that opens and closes the opening 36 and attaches and detaches a lid to and from the carrier body, and a shutter member drive mechanism (not illustrated) that drives the shutter member.

Each of the substrate conveyance mechanisms TR1 and TR2 includes two hands 37, an advance/retraction drive unit 38, and a lift rotary drive unit 39. Each of the hands 37 holds the wafer W. Each of the hands 37 is movably attached to the advance/retraction drive unit 38. The advance/retraction drive unit 38 can individually move the two hands 37. The two hands 37 are configured in the same manner as the two hands 47 included in the substrate conveyance mechanism TR3. Each of the hands 37 is configured to be able to hold the temperature measurement wafer 1.

The lift rotary drive unit 39 lifts, lowers, and rotates each of the hands 37 by lifting, lowering, and rotating the advance/retraction drive unit 38. That is, as illustrated in FIG. 5, the lift rotary drive unit 39 can move the advance/retraction drive unit 38 in the up/down direction (z direction) and can rotate the advance/retraction drive unit 38 around a vertical axis AX1. The advance/retraction drive unit 38 and the lift rotary drive unit 39 each include, for example, an electric motor. Each of the two substrate conveyance mechanisms TR1 and TR2 is fixed to the floor of the indexer block 31 so as not to be movable in a horizontal direction. Each of the two substrate conveyance mechanisms TR1 and TR2 may be provided to be movable in the horizontal direction. One of the two substrate conveyance mechanisms TR1 and TR2 may be omitted.

A substrate placement unit PS1 is provided between the indexer block 31 and a processing layer 32A on the upper side in the processing block 32. A substrate placement unit PS2 is provided between the indexer block 31 and a processing layer 32B on the lower side in the processing block 32. Each of the substrate placement units PS1 and PS2 is configured such that one or a plurality of wafers W can be placed thereon.

The substrate placement units PS1 to PS2 are configured in such that the temperature measurement wafer 1 can be placed thereon. When the substrate placement units are configured in such that a plurality of wafers W can be placed thereon, the substrate placement units PS1 to PS2 include a plurality of placement members disposed in the up/down direction. At this time, the substrate placement units may be configured in such that the temperature measurement wafer 1 is placed on the uppermost placement member because of the size of the gap between the two placement members. The substrate placement units may also be configured in such that the temperature measurement wafer 1 can be placed on a placement member other than the uppermost placement member.

The substrate conveyance mechanism TR1 conveys the wafer W from the carrier C placed on the opener 33 to one of the two substrate placement units PS1 and PS2. The substrate conveyance mechanism TR2 conveys the wafer W from the carrier C placed on the opener 34 to one of the two substrate placement units PS1 and PS2. Two or more openers 33 and 34 may be provided in the up/down direction. In this case, for example, the substrate conveyance mechanism TR1 can take out the wafer W from the carrier C placed on two or more openers 33 provided in the up/down direction.

The processing block 32 includes a coating unit 41, a conveyance space 42, and a thermal processing block 97. In Example 1, the processing block 32 has a configuration in which two processing layers having the same configuration are stacked. That is, as illustrated in FIG. 5, the processing block 32 has a configuration in which the processing layer 32A on the upper side and the processing layer 32B on the lower side are stacked in the up/down direction.

The coating unit 41 performs coating processing of applying a processing liquid to the wafer W. Examples of the processing liquid include a photoresist liquid or a liquid for forming an antireflection film. One coating unit 41 is provided for each of the processing layer 32A and the processing layer 32B. Of the two coating units 41, one disposed in the processing layer 32A is defined as coating unit 41A. One disposed in the processing layer 32B is defined as coating unit 41B to distinguish the two. Each of the coating units 41A and 41B includes a series of mechanisms used for coating processing, such as a nozzle for applying a processing liquid to the wafer W and a spin chuck for holding the wafer W.

The conveyance space 42 is a rectangular space linearly extending in the right-and-left direction (x direction) in plan view. The coating unit 41 and the thermal processing unit 43 are disposed so as to sandwich the conveyance space 42 from front and back. That is, the coating unit 41 is disposed on the front side of the conveyance space 42, and the thermal processing unit 43 is disposed on the back side (rear side) of the conveyance space 42.

One conveyance space 42 is disposed in each of the processing layer 32A and the processing layer 32B. Of the two conveyance spaces 42, one disposed in the processing layer 32A is defined as conveyance space 42A. One disposed in the processing layer 32B is defined as conveyance space 42B to distinguish the two.

Each of the conveyance spaces 42A and 42B includes a standby unit 45, a receiving unit 46, and a substrate conveyance mechanism TR3. Details of the standby unit 45 and the receiving unit 46 will be described later.

FIG. 6A is a side view of the substrate conveyance mechanism TR3. FIG. 6B is a plan view of the substrate conveyance mechanism TR3. The substrate conveyance mechanism TR3 conveys the wafer W or the temperature measurement wafer 1 in each of the conveyance spaces 42A and 42B. That is, the substrate conveyance mechanism TR3 can load and unload the wafer W into and from the coating unit 41. The substrate conveyance mechanism TR3 can load and unload the wafer W into and from the thermal processing unit 43. The substrate conveyance mechanism TR3 can load and unload the wafer W into and from the standby unit 45.

The substrate conveyance mechanism TR3 includes two hands 47, an advance/retraction drive unit 48, and a rotary drive unit 49. The substrate conveyance mechanism TR3 further includes a first moving mechanism 51 and a second moving mechanism 52. One of the two hands 47 is defined as a hand 47A, and the other is defined as a hand 47B to distinguish the two.

Each of the hands 47A and 47B holds the wafer W. Each of the two hands 47A and 47B has one base 50 and two tips 93 separated from the base 50. Three projections 95 are provided inside the base 50 and the two tips 93. The wafer W is placed on the three projections 95. Each of the three projections 95 has a suction unit 96. The suction unit 96 is connected to an intake system (not illustrated). The two hands 47A and 47B are not limited to the shape illustrated in FIG. 6B.

The two hands 47A and 47B can individually advance and retract in the horizontal directions. The advance/retraction drive unit 48 movably supports the hands 47A and 47B, and advances and retracts each of the hand 47A and the hand 47B. To drive one hand 47A, the advance/retraction drive unit 48 includes an electric motor, a linear screw shaft, a movable member having a hole engaged with the screw shaft, and a guide that guides the movable member, for example. The rotary drive unit 49 rotates the advance/retraction drive unit 48 around a vertical axis AX2. This configuration can change the orientations of the two hands 47A and 47B. The rotary drive unit 49 includes an electric motor.

The first moving mechanism 51 moves the rotary drive unit 49 in the x direction. This configuration can move the two hands 47A and 47B and the advance/retraction drive unit 48 in the x direction. The second moving mechanism 52 moves the rotary drive unit 49 in the up/down direction (z direction). This configuration can move the two hands 47A and 47B and the advance/retraction drive unit 48 in the z direction. That is, each of the first moving mechanism 51 and the second moving mechanism 52 can move the two hands 47A and 47B and the advance/retraction drive unit 48 in the xz directions. Each of the first moving mechanism 51 and the second moving mechanism 52 includes an electric motor. Each of the first moving mechanism 51 and the second moving mechanism 52 may be provided on the floor.

In the thermal processing block 97, thermal processing units 43 stacked in multiple rows are disposed in parallel in the x direction. Each of the thermal processing units 43 performs thermal processing on the wafer W. FIG. 7 is a diagram illustrating a disposition of the thermal processing units 43 in the processing block 32. FIG. 7 corresponds to a sectional view taken along arrows b-b in FIG. 4. Each of the processing layer 32A and the processing layer 32B included in the processing block 32 includes one thermal processing block 97. Of the two thermal processing blocks 97 included in the processing block 32, one disposed in the processing layer 32A on the upper side is referred to as thermal processing block 97A, and one disposed in the processing layer 32B on the lower side is referred to as thermal processing block 97B to distinguish them.

In each of the two thermal processing blocks 97A and 97B, the thermal processing units 43 can be disposed in 3 columns × 5 rows. As illustrated in FIGS. 4 and 5, the thermal processing units 43 disposed in the left column are referred to as thermal processing units 43A. The thermal processing units 43 disposed in the center column is referred to as thermal processing units 43B. The thermal processing units 43 disposed in the right column are referred to as thermal processing units 43C to distinguish the units from the units in the other columns.

### <Configuration of Thermal Processing Unit>

Here, the configuration of the thermal processing unit 43 will be described with reference to FIGS. 8 and 9. FIG. 8 is a longitudinal sectional view of the thermal processing unit 43 in a right side view. FIG. 9 is a plan view of the thermal processing unit 43. Each of the thermal processing units 43 includes a cooling plate 53, a heating plate 54, a first support pin 55, a first pin lifting mechanism 56, a second support pin 57, a second pin lifting mechanism 58, and a local conveyance mechanism 59. These are disposed inside a casing 60.

The cooling plate 53 cools the wafer W that has been placed. The cooling plate 53 has a plate shape and is made of, for example, metal or ceramic. The cooling plate 53 is provided with a circulation flow path (not illustrated) so that cooling water adjusted to a predetermined temperature (for example, 23°C) circulates therein. Cooling water is circulated through the circulation flow path in the cooling plate 53 by an external pump. The cooling plate 53 may include a Peltier element as a cooling mechanism.

The cooling plate 53 is provided with three holes 61 in the up/down direction (z direction). The first support pin 55 having a rod shape passes through each of the three holes 61. That is, the three first support pins 55 are provided so as to penetrate the cooling plate 53. Lower ends of the three first support pins 55 are fixed to a lifting member 63. The first pin lifting mechanism 56 lifts and lowers the three first support pins 55 fixed to the lifting member 63 by lifting and lowering the lifting member 63. Each of the first pin lifting mechanism 56 and a second pin lifting mechanism 58 described later includes an electric motor or an actuator driven by the air.

The wafer W comes into contact with the cooling plate 53 via a conveyance arm 65 described later, for example. That is, the wafer W is indirectly cooled. In this regard, the wafer W may be configured to be directly placed on the cooling plate 53. The conveyance arm 65 may have a cooling function like the cooling plate 53. In this case, the cooling plate 53 does not have to be provided.

The heating plate 54 heats the wafer W that has been placed by increasing the temperature of the wafer W to a predetermined temperature. The heating plate 54 is disposed side by side in the horizontal direction (y direction) with respect to the cooling plate 53. The heating plate 54 has a plate shape and is made of metal or ceramic. The heating plate 54 includes a heater (for example, an electric heater).

The heating plate 54 is provided with three holes 66 in the up-down direction. The second support pin 57 having a rod shape passes through each of the three holes 66. That is, the three second support pins 57 are provided so as to penetrate the heating plate 54. Lower ends of the three second support pins 57 are fixed to a lifting member 67. The second pin lifting mechanism 58 lifts and lowers the three second support pins 57 fixed to the lifting member 67 by lifting and lowering the lifting member 67.

The heating plate 54 is provided with a cover 68 for covering the wafer W on an upper surface 54A of the heating place. The cover lifting mechanism 69 is connected to the cover 68 to lift and lower the cover 68. The cover lifting mechanism 69 includes an electric motor or an actuator driven by the air. In FIG. 4, a ring-shaped exhaust port 71 is provided on the upper surface 54A of the heating plate 54 so as to surround the placed wafer W. When the cover 68 is at the lower position covering the wafer W, the exhaust port 71 can exhaust the gas in a processing space SP.

See FIG. 9. The local conveyance mechanism 59 conveys the temperature measurement wafer 1 between the cooling plate 53 and the heating plate 54 inside the thermal processing unit 43. The local conveyance mechanism 59 includes a conveyance arm 65 and an arm drive mechanism 73.

The conveyance arm 65 is a flat plate-like member, and is formed of a material having favorable heat conductivity (for example, aluminum). Three proximity balls 74 are provided on the upper surface of the conveyance arm 65. The three proximity balls 74 project upward from the upper surface. Thus, when the wafer W is placed on the upper surface of the conveyance arm 65, a slight gap is formed between the lower surface of the wafer W and the upper surface of the conveyance arm 65 because of the three proximity balls 74. Two slits 75 are formed in the conveyance arm 65. The two slits 75 are formed on the heating plate 54 side of the conveyance arm 65 and extend in parallel in the front-to-rear direction (y direction). For example, three first support pins 55 in a lifted state enter the two slits 75.

The arm drive mechanism 73 can linearly move the conveyance arm 65 between above the cooling plate 53 and above the heating plate 54. The arm drive mechanism 73 includes a horizontal movement unit 73H and a vertical movement unit 73V. The horizontal movement unit 73H moves the conveyance arm 65 in the horizontal direction (y direction). The horizontal movement unit 73H includes, for example, an electric motor, a guide rail, and a timing belt. The vertical movement unit 73V moves the conveyance arm 65 in the vertical direction (z direction). The vertical movement unit 73V includes, for example, an electric motor or an air cylinder.

As illustrated in FIG. 8, the casing 60 is provided with a load/unload port 60A. The substrate conveyance mechanism TR3 causes at least one of the two hands 47A and 47B to enter from the load/unload port 60A to load and unload the wafer W. As illustrated in FIG. 8, the inside of the casing 60 is exhausted. In addition, the substrate conveyance mechanism TR3 is configured to cause at least one of the two hands 47A and 47B to enter from the load/unload port 60A to load and unload the temperature measurement wafer 1. In Example 1, the substrate conveyance mechanism TR3 and the local conveyance mechanism 59 are used to convey the temperature measurement wafer 1 between the heating plate 54 and the standby unit 45. In Example 1, the substrate conveyance mechanism TR3 and the local conveyance mechanism 59 correspond to a conveyance unit in the present invention.

### <Configuration of Standby Unit>

Next, a configuration of the standby unit 45 will be described. FIG. 10A is a side view of the standby unit 45. FIG. 10B is a plan view of the standby unit 45. The standby unit 45 is used as a station that allows the temperature measurement wafer 1 to wait inside the substrate processing apparatus 30. In FIGS. 10A and 10B, the temperature measurement wafer 1 in a standby state on the standby unit 45 is indicated by a two-dot chain line.

In Example 1, the standby unit 45 is disposed in the conveyance space 42. As an example, as illustrated in FIGS. 4 and 5, the standby unit 45 is disposed at the right end of the conveyance space 42. The standby unit 45 includes a hold rotation unit 76, a base unit 77, a notch detection unit 78, a centering mechanism 79, and a power feeding unit 80.

The hold rotation unit 76 includes a spin chuck 81 and a rotary drive unit 83. The spin chuck 81 holds the back surface of the temperature measurement wafer 1 through vacuum suction, for example. The spin chuck 81 may hold the end of the temperature measurement wafer 1 with three or more holding pins (not illustrated). The rotary drive unit 83 rotates the spin chuck 81 around a vertical axis AX3. The rotary drive unit 83 includes an electric motor (for example, a stepping motor). The hold rotation unit 76 corresponds to a rotation mechanism in the present invention.

The base unit 77 has a plate shape, and is formed of, for example, metal or ceramic. The base unit 77 holds the lower side of the hold rotation unit 76. In Example 1, one end side of the base unit 77 is connected to the second moving mechanism 52 (see FIG. 5). That is, the base unit 77 is moved in the z direction by the second moving mechanism 52 independently of the substrate conveyance mechanism TR3. As the base unit 77 moves in the z direction, the standby unit 45 can move in the z direction independently of the substrate conveyance mechanism TR3. Since the standby unit 45 moves in the z direction independently of the substrate conveyance mechanism TR3, it is possible to prevent the substrate conveyance mechanism TR3 conveying the wafer W or the like to the thermal processing unit 43 (particularly to the thermal processing unit 43C) from interfering with the standby unit 45.

The notch detection unit 78 is constituted by, for example, a transmissive or reflective optical sensor. The notch detection unit 78 detects the presence or absence of the notch 10 provided in the temperature measurement wafer 1. In FIG. 10A, the notch detection unit 78 performs a detection operation at a left end position of the temperature measurement wafer 1. The detection position to be detected by the notch detection unit 78 may be any position on the outer edge of the temperature measurement wafer 1. The notch detection unit 78 is configured to be movable above the temperature measurement wafer 1 along the outer edge of the temperature measurement wafer 1. With the notch detection unit 78 moving to an appropriate position and detecting the presence or absence of the notch 10, the orientation of the temperature measurement wafer 1 can be appropriately adjusted such that the notch 10 of the temperature measurement wafer 1 is positioned in an appropriate direction with respect to the center of the temperature measurement wafer 1.

The centering mechanism 79 aligns the center of the temperature measurement wafer 1 with the vertical axis AX3, which is the rotation center of the hold rotation unit 76. As illustrated in FIG. 12B, the centering mechanism 79 may include, for example, two members 79A and 79B for sandwiching the temperature measurement wafer 1 from two horizontal directions. Each of the members 79A and 79B is driven by, for example, an electric motor.

The power feeding unit 80 transmits power to the temperature measurement wafer 1 waiting in the standby unit 45. The power feeding unit 80 transmits power to the power receiving unit 13 of the temperature measurement wafer 1 in a wireless manner. That is, the all-solid-state secondary battery 21 can be charged with the power feeding unit 80 and the power receiving unit 13 in a state where the temperature measurement wafer 1 is waiting in the standby unit 45. The power feeding unit 80 is embedded in the spin chuck 81, as an example. The place where the power feeding unit 80 is disposed is not limited to this example, and it may be disposed outside the hold rotation unit 76. As the power feeding unit 80, a disk-shaped wireless charger or the like can be used. As a method for feeding power in a wireless manner, an electromagnetic induction method, an electric field coupling method, an electromagnetic wave method, or the like may be appropriately used.

The receiving unit 46 receives information wirelessly transmitted from the transmission unit 8 of the temperature measurement wafer 1. As an example, the receiving unit 46 is disposed on the ceiling of the conveyance space 42A and the ceiling of the conveyance space 42B. In Example 1, the receiving unit 46 is disposed at the center in the x direction of the ceiling of the conveyance space 42. That is, as illustrated in FIG. 4, the receiving unit 46 is disposed on the front side (the lower side in FIG. 4) of the thermal processing unit 43B in plan view.

As illustrated in FIG. 3, the substrate processing apparatus 30 further includes a control unit 85, an operation unit 87, a storage unit 89, and a notification unit 91.

The control unit 85 includes an information processing unit such as a central processing unit (CPU). The control unit 85 integrally controls operation of each unit constituting the substrate processing apparatus 30. The control unit 85 includes a temperature control unit 86 and a cooling control unit 88. The temperature control unit 86 controls the operation of the heater disposed on the heating plate 54. The temperature of the heating plate 54 is adjusted by controlling the operation of the heater. The temperature control unit 86 adjusts the temperature of the heating plate 54 based on the temperature data of the heating plate 54 transmitted from the transmission unit 8. The cooling control unit 88 controls each configuration of the substrate processing apparatus 1 so as to cool the temperature measurement wafer 1 when the temperature of the battery unit 7 has a value equal to or more than an operation threshold F2. The cooling control unit 88 controls each configuration of the substrate processing apparatus 1 so as to cool the temperature measurement wafer 1 when the temperature of the power receiving substrate 9 has a value equal to or more than the operation threshold F2. As an example, the cooling control unit 88 controls operations of the cooling plate 53, the substrate conveyance mechanism TR3, and the like.

The operation unit 87 includes a display unit that displays various types of information and an input unit that accepts an input operation. Examples of the display unit include a liquid crystal monitor. Examples of the input unit include a keyboard, a mouse, a touch panel, various buttons, and a combination thereof. Information on the input operation accepted by the operation unit 87 is transmitted to the control unit 85. The control unit 85 is configured to be able to integrally control the operation of each unit constituting the substrate processing apparatus 30 according to the input operation accepted by the operation unit 87.

The storage unit 89 includes, as an example, at least one of a read-only memory (ROM), a random-access memory (RAM), and a hard disk. The storage unit 89 stores various conditions of the heating processing and the cooling processing, an operation program necessary for controlling the substrate processing apparatus 30, an operation program necessary for controlling the temperature measurement wafer 1, and the like.

Information on a predetermined value F1, the operation threshold F2, and an ideal temperature F3 is stored in advance in the storage unit 89. The predetermined value F1 is a threshold value related to the remaining power amount of the temperature measurement wafer 1. As will be described later, when the remaining amount of power in the all-solid-state secondary battery 21 of the temperature measurement wafer 1 has a value equal to or less than the predetermined value F1, the control unit 85 controls each unit of the substrate processing apparatus 30 so as to convey the temperature measurement wafer 1 to the standby unit 45 and perform charging.

The operation threshold F2 is a threshold related to the temperature of the temperature measurement wafer 1. As will be described later, when the temperature of at least one of the battery substrate 7 and the power receiving substrate 9 has a value equal to or more than the operation threshold F2, the control unit 85 controls each unit of the substrate processing apparatus 30 to control each unit of the substrate processing apparatus 30 so as to avoid an increase in the temperature of the temperature measurement wafer 1.

The ideal temperature F3 is information on an ideal temperature of the heating plate 54. The control unit 85 adjusts the temperature of the heating plate 54 to the ideal temperature F3 based on the actual temperature data of the heating plate 54 obtained through measurement with the temperature measurement wafer 1.

The notification unit 91 notifies that the temperature of the battery substrate 7 or the power receiving substrate 9 has a value equal to or more than the operation threshold F2 by using sound, light, characters, or the like. Examples of the notification unit 91 include a warning device that generates a warning sound and a display unit of the operation unit 87 that displays character information.

### <Overview of Substrate Processing Method>

An overview of a processing step with respect to the wafer W performed using the substrate processing apparatus 30 is as follows. First, the wafer W is conveyed from the indexer block 31 to the processing block 32. That is, in the indexer block 31, the substrate conveyance mechanism TR1 takes out the wafer W from the carrier C placed on the opener 33. The substrate conveyance mechanism TR1 places the wafer W unloaded from the carrier C on the substrate placement unit PS1 (or the substrate placement unit PS2).

Next, the substrate conveyance mechanism TR3 conveys the wafer W placed on the substrate placement unit PS1 (or the substrate placement unit PS2) to the coating unit 41 of the processing block 32. Coating processing of applying a processing liquid such as a photoresist liquid is performed on the wafer W conveyed to the coating unit 41. After the coating processing is completed, the substrate conveyance mechanism TR3 conveys the wafer W subjected to the coating processing to the thermal processing unit 43. The wafer W conveyed to the thermal processing unit 43 is placed on the cooling plate 53 and subjected to cooling processing, and further placed on the heating plate 54 and subjected to heating processing.

After completion of the cooling processing and the heating processing, that is, the thermal processing, the substrate conveyance mechanism TR3 unloads the wafer W from the thermal processing unit 43 and places the wafer W on the substrate placement unit PS1 (or the substrate placement unit PS2). The substrate conveyance mechanism TR2 loads the wafer W into the carrier C placed on the opener 34. By performing the coating processing and the thermal processing in this manner, the processing step with respect to the wafer W is completed.

When the heating processing is performed on the wafer W, the temperature of the heating plate 54 is required to be strictly uniform as a whole. Thus, at the time of start-up of the substrate processing apparatus 30 and at the time of periodic maintenance of the substrate processing apparatus 30, the temperature of each of the heating plates 54 is measured using the temperature measurement wafer 1. Then, the temperature of the heating plate 54 is adjusted according to the temperature data measured by the temperature measurement wafer 1.

### <Temperature Measurement Method Using Temperature Measurement Wafer>

Here, a step of measuring the temperature using the temperature measurement wafer 1 in the substrate processing unit 100 according to Example 1 will be described. FIG. 11 is a flowchart illustrating a series of steps for measuring the temperature using the temperature measurement wafer 1.

### Step S1 (Loading into substrate processing apparatus)

When the step of temperature measurement is started, first, the temperature measurement wafer 1 is loaded into the substrate processing apparatus 30. The step of loading the temperature measurement wafer 1 into the substrate processing apparatus 30 is the same as the step of loading the wafer W into the substrate processing apparatus 30. That is, the temperature measurement wafer 1 is accommodated in the carrier C and placed on the stage 35. The substrate conveyance mechanism TR1 unloads the temperature measurement wafer 1 from the carrier C and loads the temperature measurement wafer 1 into the indexer block 31 through the opening 91. The step of loading the temperature measurement wafer 1 from the outside of the substrate processing apparatus 30 to the inside of the indexer block 31 may be performed using the substrate conveyance mechanism TR2.

### Step S2 (Conveyance to thermal processing unit)

When the temperature measurement wafer 1 is loaded into the indexer block 31, a step of conveying the temperature measurement wafer 1 to the thermal processing unit 43 is performed. Here, among the three columns of thermal processing units 43A to 43C arranged in the x direction, the temperature of the thermal processing unit 43A is first measured.

In the case of measuring the temperature of the thermal processing unit 43 disposed in the upper processing block 32A, the substrate conveyance mechanism TR1 places the temperature measurement wafer 1 on the substrate placement unit PS1. The substrate conveyance mechanism TR3 disposed in the conveyance space 42A of the processing block 32A holds the wafer body 2 of the temperature measurement wafer 1 placed on the substrate placement unit PS1 with the hand 47. Then, as illustrated in FIG. 12, the substrate conveyance mechanism TR3 conveys the temperature measurement wafer 1 from the substrate placement unit PS1 to the thermal processing unit 43. FIG. 12 illustrates a state in which the temperature measurement wafer 1 is conveyed from the substrate placement unit PS1 to the load/unload port 60A of the thermal processing unit 43. In the plan view of FIG. 12 and the like, the description of the configuration of the temperature measurement wafer 1 excluding the notch 10 and the measurement substrate 5 is omitted.

When the temperature of the thermal processing unit 43 disposed in the lower processing block 32B is measured, the substrate conveyance mechanism TR1 places the temperature measurement wafer 1 on the substrate placement unit PS2. The substrate conveyance mechanism TR3 disposed in the conveyance space 42B of the processing block 32B holds the wafer body 2 of the temperature measurement wafer 1 placed on the substrate placement unit PS1 with the hand 47 and conveys the wafer body to the thermal processing unit 43.

### Step S3 (Temperature measurement)

After the temperature measurement wafer 1 is conveyed to the thermal processing unit 43, the temperature measurement wafer 1 is placed on the heating plate 54, and the temperature of the heating plate 54 is measured. FIGS. 13A to 13C and FIGS. 14A to 14C are diagrams for describing an operation of measuring the temperature of the heating plate 54 in a predetermined thermal processing unit 43. It is assumed that the substrate conveyance mechanism TR3 holds the temperature measurement wafer 1 with the lower hand 47B. In FIG. 13A and the like, for convenience of description, the temperature sensor 3, the measurement substrate 5, and the like in the temperature measurement wafer 1 are omitted.

See FIG. 13A. It is assumed that the substrate conveyance mechanism TR3 holds the temperature measurement wafer 1 with the lower hand 47B. The substrate conveyance mechanism TR3 loads the temperature measurement wafer 1 into the internal space of the thermal processing unit 43 via the load/unload port 60A of the casing 60 while holding the temperature measurement wafer 1.

See FIG. 13B. The substrate conveyance mechanism TR3 moves the lower hand 47B holding the temperature measurement wafer 1 above the cooling plate 53. Thereafter, the temperature measurement wafer 1 is delivered onto the three first support pins 55 provided so as to penetrate the cooling plate 53. That is, the first pin lifting mechanism 56 (see FIG. 8) lifts the three first support pins 55 to place the temperature measurement wafer 1 on the three first support pins 55. In FIG. 13B, the conveyance arm 65 of the local conveyance mechanism 59 is in contact with the cooling plate 53.

See FIG. 13C. After the temperature measurement wafer 1 is delivered onto the three first support pins 55, the lower hand 47B is retracted from the upper side of the cooling plate 53. After the lower hand 47B is retracted, the local conveyance mechanism 59 lifts the conveyance arm 65 so as to separate the arm from the cooling plate 53.

See FIG. 14A. The temperature measurement wafer 1 is placed on the conveyance arm 65 by lifting the conveyance arm 65. Thereafter, the first pin lifting mechanism 56 (see FIG. 8) lowers the three first support pins 55. As a result, the temperature measurement wafer 1 placed on the three first support pins 55 is delivered onto the conveyance arm 65 of the local conveyance mechanism 59. The conveyance arm 65 of the local conveyance mechanism 59 is movable between above the cooling plate 53 and above the heating plate 54.

See FIG. 14B. Thereafter, the local conveyance mechanism 59 moves the conveyance arm 65 holding the temperature measurement wafer 1 from above the cooling plate 53 to above the heating plate 54. After the conveyance arm 65 is moved above the heating plate 54, the temperature measurement wafer 1 is delivered onto the three second support pins 57 provided so as to penetrate the heating plate 54. That is, the second pin lifting mechanism 58 (see FIG. 8) lifts the three second support pins 57 to place the temperature measurement wafer 1 onto the three second support pins 57.

See FIG. 14C. After the temperature measurement wafer 1 is delivered onto the three second support pins 57, first, the local conveyance mechanism 59 moves the conveyance arm 65 from above the heating plate 54 to above the cooling plate 53, and then lowers the conveyance arm 65 to bring the arm into contact with the cooling plate 53. Then, second pin lifting mechanism 58 (see FIG. 8) lowers the three second support pins 57. The temperature measurement wafer 1 is thus placed on the heating plate 54. Thereafter, the cover lifting mechanism 69 (see FIG. 8) may lower the cover 68 to such an extent that the placement position of the temperature measurement wafer 1 does not move. FIG. 15 is a plan view illustrating a state in which the temperature measurement wafer 1 is placed on the heating plate 54 of the thermal processing unit 43A.

After the temperature measurement wafer 1 is placed on the heating plate 54, temperature measurement is performed on the heating plate 54 as a measurement subject. That is, the temperature of the heating plate 54 subjected to the heating control by the control unit 85 is measured by the temperature sensor 3 of the temperature measurement wafer 1. Each of the plurality of temperature sensors 3 illustrated in FIG. 1A detects the temperature of the heating plate 54. A signal of each of the plurality of temperature sensors 3 is sent to the A/D converter 6 included in the measurement substrate 5. The A/D converter 6 converts the signal transmitted from the temperature sensor 3 into temperature data. The plurality of temperature sensors 3 is uniformly disposed over the entire surface of the temperature measurement wafer 1. Thus, temperature data at a plurality of locations is acquired over the entire surface of the heating plate 54.

### Step S4 (Transmission of temperature data)

When the temperature data of the heating plate 54 is acquired through the temperature measurement, the temperature data is transmitted to the outside of the temperature measurement wafer 1. That is, the temperature data acquired through the digital conversion by the A/D converter 6 is sent to the transmission unit 8 of the measurement substrate 5. The transmission unit 8 transmits the temperature data of the heating plate 54 to the receiving unit 46 included in the substrate processing apparatus 30 in real time.

As illustrated in FIG. 15, when the temperature measurement wafer 1 is placed on the heating plate 54 of the thermal processing unit 43A, the orientation of the temperature measurement wafer 1 in the horizontal direction is determined in advance so that the measurement substrate 5 of the temperature measurement wafer 1 faces the receiving unit 46. The "state where the measurement substrate 5 faces the receiving unit 46" means a "state where the orientation of the temperature measurement wafer 1 around the axis in the z direction is determined such that the distance between the measurement substrate 5 and the receiving unit 46 becomes the shortest". In other words, the orientation of the measurement substrate 5 at the time when the substrate conveyance mechanism TR3 holds the temperature measurement wafer 1 is determined such that a distance T1 between the measurement substrate 5 and the receiving unit 46 becomes the shortest when the temperature measurement wafer 1 is placed on the heating plate 54 of the thermal processing unit 43A (see FIG. 15).

By placing the temperature measurement wafer 1 onto the heating plate 54 such that the measurement substrate 5 faces the receiving unit 46, the temperature data transmitted from the transmission unit 8 of the temperature measurement wafer 1 is transmitted to the receiving unit 46 of the substrate processing apparatus 30 with higher accuracy. That is, by further shortening the distance between the measurement substrate 5 and the receiving unit 46, the accuracy of wireless communication between the temperature measurement wafer 1 and the substrate processing apparatus 30 can be improved.

### Step S5 (Temperature adjustment of heating plate)

When the temperature data is transmitted from the temperature measurement wafer 1 to the substrate processing apparatus 30, the substrate processing apparatus 30 adjusts the temperature of the heating plate 54 based on the acquired temperature data. The temperature data received by the receiving unit 46 is transmitted to the control unit 85 of the substrate processing apparatus 30. The control unit 85 compares the actual temperature data of the heating plate 54 obtained through the measurement of the temperature measurement wafer 1 with the information of the ideal temperature F3 stored in the storage unit 89. Temperature control unit 86 included in control unit 85 controls the operation of the heater disposed on heating plate 54 such that the temperature of heating plate 54 becomes the ideal temperature F3.

By controlling the operation of the heater in real time, the temperature of the heating plate 54 is quickly reset. The temperature measurement wafer 1 placed on the heating plate 54 again measures the reset temperature of the heating plate 54 to acquire temperature data. The reset temperature data is transmitted from the transmission unit 8 to the receiving unit 46 in a wireless manner, and is further transmitted to the control unit 85. In this manner, while the operation of measuring the temperature of the heating plate 54 and the operation of resetting the temperature of the heating plate 54 are repeated in real time in a state where the temperature measurement wafer 1 is placed on the heating plate 54, the temperature of the heating plate 54 is quickly adjusted to the ideal temperature F3.

The temperature measurement wafer 1 is configured to be able to transmit temperature data of the heating plate 54 to the outside of the temperature measurement wafer 1 in a wireless manner. The temperature measurement wafer 1 is configured to be able to transmit temperature data in a state of being placed on the heating plate 54 as a measurement subject. Thus, the control unit 85 of the substrate processing apparatus 30 can acquire temperature data of the heating plate 54 in real time, and can repeat measurement and resetting of the temperature of the heating plate 54 in real time. As a result, the temperature of the heating plate 54 can be quickly and accurately adjusted to the ideal temperature F3.

Through the steps up to step S5, the work of measuring and adjusting the temperature of the heating plate 54 for one thermal processing unit 43 is completed. After step S5 is completed, the subsequent process branches according to the state of the temperature measurement wafer 1 according to the selection of steps Q1 to Q4 illustrated in FIG. 11.

In step Q1, selection is performed depending on whether to change the orientation of the measurement substrate 5 in the temperature measurement wafer 1. As an example, schedule data regarding the order in which the temperature measurement wafer 1 measures the plurality of thermal processing units 43 is stored in the storage unit 89, and the control unit 85 makes a determination using the schedule data, whereby the selection of step Q1 can be performed.

Next, when the thermal processing unit 43 on which temperature measurement is to be performed by the temperature measurement wafer 1 next is in the same column as the thermal processing unit 43 on which temperature measurement has most recently been performed, the positional relationship between the measurement substrate 5 and the receiving unit 46 in plan view does not change, and thus it is not necessary to change the orientation of the measurement substrate 5. In this case, the selection in step Q1 is "No". As a specific example, when the temperature is measured for the thermal processing unit 43A disposed in the uppermost row in the left column, and thereafter the temperature is measured for the thermal processing unit 43A disposed in the second row from the top in the left column, the selection in step Q1 is "No".

On the other hand, when the thermal processing unit 43 on which temperature measurement is to be performed by the temperature measurement wafer 1 next is in a different column from the thermal processing unit 43 on which temperature measurement has most recently been performed, the positional relationship between the measurement substrate 5 and the receiving unit 46 in plan view changes, and thus, it is preferable to change the orientation of the measurement substrate 5. In this case, the selection in step Q1 is "Yes". As a specific example, when the temperature is measured for the thermal processing unit 43A disposed in the left column, and thereafter, the temperature is measured for the thermal processing unit 43B disposed in the center column, the selection in step Q1 is "Yes".

In step Q2, selection is performed depending on the remaining power amount of the all-solid-state secondary battery 21 in the temperature measurement wafer 1. As an example, information indicating the remaining power amount of the all-solid-state secondary battery 21 is transmitted from the battery substrate 7 to the transmission unit 8 of the measurement substrate 5, data of the remaining power amount is further wirelessly communicated from the transmission unit 8 to the receiving unit 46, and the data is further transmitted to the control unit 85. Then, the control unit 85 compares the data of the remaining power amount of the all-solid-state secondary battery 21 with the predetermined value F1 stored in the storage unit 89, whereby the selection of step Q2 can be performed.

When the remaining power amount of the all-solid-state secondary battery 21 has a value larger than the predetermined value F1, it is determined that the operation of moving to the next thermal processing unit 43 and measuring the temperature of the heating plate 54 can be continued. In this case, the selection in step Q1 is "No". On the other hand, when the remaining power amount of the all-solid-state secondary battery 21 has a value equal to or less than the predetermined value F1, it is determined that there is a possibility that the operation of the temperature measurement wafer 1 stops due to the power shortage of the all-solid-state secondary battery 21, and the temperature measurement cannot be performed if the operation of moving to the next thermal processing unit 43 and measuring the temperature of the heating plate 54 is continued. In this case, the selection in step Q2 is "Yes".

In step Q3, selection is performed depending on the temperatures of the battery substrate 7 and the power receiving substrate 9 in the temperature measurement wafer 1. The battery temperature detection unit 11 measures the temperature of the battery substrate 7 at an appropriate timing. The substrate temperature detection unit 14 measures the temperature of the power receiving substrate 9 at an appropriate timing. The temperature data of the battery substrate 7 is transmitted from the battery temperature detection unit 11 to the transmission unit 8 of the measurement substrate 5. The temperature data of the power receiving substrate 9 is transmitted from the substrate temperature detection unit 14 to the transmission unit 8 of the measurement substrate 5. The transmission unit 8 wirelessly transmits the temperature data of the battery substrate 7 and the temperature data of the power receiving substrate 9 to the receiving unit 46. The control unit 85 can select step Q3 by comparing the temperature data with the operation threshold F2 stored in the storage unit 89.

When both the temperature of the battery substrate 7 and the temperature of the power receiving substrate 9 have values less than the operation threshold F2, the temperature of the battery substrate 7 and the temperature of the power receiving substrate 9 are sufficiently low. Thus, it is determined that the operation of moving to the next thermal processing unit 43 and measuring the temperature of the heating plate 54 can be continued. In this case, the selection in step Q3 is "No". On the other hand, when at least one of the temperature of the battery substrate 7 and the temperature of the power receiving substrate 9 has a value equal to or more than the operation threshold F2, the temperature of the battery substrate 7 or the power receiving substrate 9 is excessively high. Thus, it is determined that there is a possibility that the operation of the temperature measurement wafer 1 stops due to the high temperature of the battery substrate 7 or the power receiving substrate 9, and the temperature measurement cannot be performed if the operation of moving to the next thermal processing unit 43 and measuring the temperature of the heating plate 54 is continued. In this case, the selection in step Q3 is "Yes".

In step Q4, selection is performed depending on whether the process of temperature measurement with the temperature measurement wafer 1 has been completed for all of the thermal processing units 43 whose temperatures should be measured. When there is the thermal processing unit 43 in which the temperature measurement and the temperature adjustment of the heating plate 54 are not completed, the selection of step Q4 is "No". On the other hand, when the temperature measurement and the temperature adjustment of the heating plate 54 have been completed for all the thermal processing units 43, the selection in step Q4 is "Yes".

Hereinafter, the operation of the temperature measurement wafer 1 performed in accordance with the selection of steps Q1 to Q4 will be described.

### (A) When Temperature Measurement is Performed on Next Thermal Processing Unit

First, a case where all the selections in steps Q1 to Q4 are "No" will be described. When all the selections of steps Q1 to Q4 are "No", the temperature measurement wafer 1 moves to the next thermal processing unit 43 and performs work such as temperature measurement. That is, when all the selections of steps Q1 to Q3 are "No", it is determined that the temperature measurement wafer 1 can continue to operate as it is. When the selection in step Q4 is "No", it is determined that there is a thermal processing unit 43 on which work such as temperature measurement needs to be performed. Here, a case where temperature measurement is continued by moving from the thermal processing unit 43A disposed at the uppermost row to the thermal processing unit 43A disposed at the second row from the top will be described (see FIG. 7).

When all the selections in steps Q1 to Q4 are "No", the processing returns to step S2 to perform steps S2 to S5 again. That is, after step S5 of adjusting the temperature of the heating plate 54 is completed, the temperature measurement wafer 1 is conveyed from the thermal processing unit 43A disposed at the uppermost row to the thermal processing unit 43A disposed at the second row from the top (step S2).

When step S2 is performed again after step S5 is completed, first, the temperature measurement wafer 1 is unloaded from the thermal processing unit 43. The operation of unloading the temperature measurement wafer 1 from the thermal processing unit 43 is performed in the reverse order of the description of FIGS. 13A to 13D and FIGS. 14A to 14B. After the substrate conveyance mechanism TR3 unloads the temperature measurement wafer 1 from the uppermost thermal processing unit 43A, the substrate conveyance mechanism TR3 moves from the uppermost thermal processing unit 43A to the thermal processing unit 43A at the second row while holding the temperature measurement wafer 1. The substrate conveyance mechanism TR3 can move to the second thermal processing unit 43A from the top when the second moving mechanism 52 lowers the substrate conveyance mechanism TR3 in the z direction.

After the substrate conveyance mechanism TR3 is moved by the second moving mechanism 52, the temperature measurement wafer 1 is placed on the heating plate 54 disposed in the second thermal processing unit 43A from the top. The step of placing the temperature measurement wafer 1 onto the heating plate 54 is as described with reference to FIGS. 13A to 13D and FIGS. 14A to 14B. After the temperature measurement wafer 1 is placed onto the heating plate 54, temperature measurement, temperature data transmission, and temperature adjustment are performed on the heating plate 54 disposed in the second thermal processing unit 43A from the top (steps S3 to S5).

After the steps up to step S5 are completed for the second thermal processing unit 43A from the top, the procedure is branched again according to the selection of steps Q1 to Q4.

### (B) When Orientation of Measurement Substrate is Changed

Next, a case where the selection in step Q1 is "Yes" will be described. When the selection in step Q1 is "Yes", steps S6 and S7 are performed after step S5 is completed. Here, it is assumed that the selection of steps Q2 to Q4 is "No".

As an example, when steps S2 to S5 are completed for the five thermal processing units 43A disposed in parallel in the z direction, next, steps S2 to S5 need to be performed for the thermal processing unit 43B disposed at the center in the x direction.

However, when the temperature measurement wafer 1 is placed on the heating plate 54 of the thermal processing unit 43B in a state where the orientation of the measurement substrate 5 is maintained, the positional relationship between the measurement substrate 5 and the receiving unit 46 in plan view is as illustrated in FIG. 16. In this case, since the measurement substrate 5 is not facing the receiving unit 46, a distance Tf between the measurement substrate 5 and the receiving unit 46 is long. For this reason, there is a concern that the accuracy of the wireless communication performed from the transmission unit 8 of the measurement substrate 5 to the receiving unit 46 may decrease.

In addition, since the measurement substrate 5 is not facing the receiving unit 46, the temperature sensor 3 and the like disposed on the temperature measurement wafer 1 may be present between the measurement substrate 5 and the receiving unit 46. As a result, the temperature sensor 3 or the like may obstruct the wireless communication between the measurement substrate 5 and the receiving unit 46. From the viewpoint of further improving the accuracy of the wireless communication from the measurement substrate 5 to the receiving unit 46, when the heating plate 54 of the thermal processing unit 43B is measured, it is desirable that the measurement substrate 5 and the receiving unit 46 have the positional relationship illustrated in FIG. 17 in plan view.

As illustrated in FIG. 17, when the temperature measurement wafer 1 is placed on the heating plate 54 of the thermal processing unit 43B, the measurement substrate 5 is located on the front side. Thus, a distance T2 between the measurement substrate 5 and the receiving unit 46 is the shortest, and thus the accuracy of the wireless communication can be improved. In this manner, when the temperature of the heating plate 54 is measured by moving to the thermal processing units 43 disposed in different columns in the x direction, it is preferable to rotate the temperature measurement wafer 1 around the axis in the z direction to change the orientation of the measurement substrate 5.

Hereinafter, step S6 and step S7 performed when the selection of step Q1 is "Yes" will be described.

### Step S6 (Conveyance to standby unit)

When step S6 is started after completion of step S5, the substrate conveyance mechanism TR3 conveys the temperature measurement wafer 1 from the thermal processing unit 43 to the standby unit 45. The operation of unloading the temperature measurement wafer 1 from the thermal processing unit 43 is performed in the reverse order of the description of FIGS. 13A to 13D and FIGS. 14A to 14B.

After the substrate conveyance mechanism TR3 unloads the temperature measurement wafer 1 from the uppermost thermal processing unit 43A, the substrate conveyance mechanism TR3 moves above the standby unit 45 while holding the temperature measurement wafer 1 as illustrated in FIG. 18. In Example 1, the substrate conveyance mechanism TR3 rotates clockwise by 90° around the axis in the z direction while holding the temperature measurement wafer 1. Then, by horizontally moving rightward in the x direction, the substrate conveyance mechanism TR3 moves above the standby unit 45.

After the substrate conveyance mechanism TR3 moves above the standby unit 45, at least one of the standby unit 45 and the substrate conveyance mechanism TR3 is appropriately shifted in the z direction, whereby the temperature measurement wafer 1 is placed onto the hold rotation unit 76 of the standby unit 45 (see FIG. 10A). The centering mechanism 79 causes the two members 79A and 79B to sandwich the temperature measurement wafer 1 from the horizontal directions, thereby aligning the center position of the temperature measurement wafer 1 with the vertical axis AX3 which is the rotation center of the hold rotation unit 76. Thereafter, the two members 79A and 79B separate from the temperature measurement wafer 1. The spin chuck 81 of the hold rotation unit 76 enables holding of the temperature measurement wafer 1 through vacuum suction. As illustrated in FIG. 19, after the temperature measurement wafer 1 is placed and held on the spin chuck 81, the hand 47 of the substrate conveyance mechanism TR3 retracts from the standby unit 45. When the temperature measurement wafer 1 is placed and held on the spin chuck 81, step S6 is completed.

### Step S7 (Rotary adjustment of wafer)

After the temperature measurement wafer 1 is conveyed to the standby unit 45 and held by the hold rotation unit 76, rotary adjustment is performed on the temperature measurement wafer 1. That is, in a state where the temperature measurement wafer 1 is placed and held on the spin chuck 81, the control unit 85 rotates the hold rotation unit 76 around the vertical axis AX3 (z-direction axis). The orientation of the measurement substrate 5 changes according to the direction and angle in which the hold rotation unit 76 rotates around the vertical axis AX3.

Thereafter, in a state where the temperature measurement wafer 1 is being rotated by the hold rotation unit 76, the notch detection unit 78 detects the position of the notch 10 of the temperature measurement wafer 1. This rotation is performed, for example, one round or a plurality of rounds. Based on the detected position (angle) of the notch 10, the control unit 85 adjusts the angle of the temperature measurement wafer 1. That is, the control unit 85 adjusts the orientation of the measurement substrate 5 in the temperature measurement wafer 1 based on the notch 10 of the temperature measurement wafer 1.

The subject of the temperature measurement wafer 1 to measure the temperature next is the heating plate 54 disposed in the thermal processing unit 43B. Thus, when the temperature measurement wafer 1 is placed on the heating plate 54 of the thermal processing unit 43B, the control unit 85 adjusts the orientation of the measurement substrate 5 so that the wireless communication between the measurement substrate 5 and the receiving unit 46 is optimized. That is, by the control unit 85 controlling the rotation drive of the hold rotation unit 76, the orientation of the measurement substrate 5 in plan view is adjusted from the state illustrated in FIG. 20A to the state illustrated in FIG. 20B. The temperature measurement wafer 1 illustrated in FIG. 20B corresponds to a state where the temperature measurement wafer 1 illustrated in FIG. 17 is rotated clockwise by 90°. By rotating the temperature measurement wafer 1 to adjust the orientation of the measurement substrate 5, step S7 is completed.

After step S7 is completed, the processing returns to the branch of steps Q2 to Q4. Here, since all the selections in steps Q2 to Q4 are "No", the processing returns to step S2. That is, the process of conveying the temperature measurement wafer 1 from the standby unit 45 to the thermal processing unit 43B starts.

Here, a step of unloading the temperature measurement wafer 1 from the standby unit 45 will be described. First, the spin chuck 81 of the hold rotation unit 76 releases vacuum suction with respect to the temperature measurement wafer 1. Then, the substrate conveyance mechanism TR3 moves to the standby unit 45 and holds the temperature measurement wafer 1 placed on the hold rotation unit 76. When the substrate conveyance mechanism TR3 is separated from the hold rotation unit 76 while holding the temperature measurement wafer 1, the temperature measurement wafer 1 is unloaded from the standby unit 45.

The step of conveying the temperature measurement wafer 1 from the standby unit 45 to the thermal processing unit 43 is as follows. That is, the substrate conveyance mechanism TR3 rotates 90° around the axis in the z direction counterclockwise while holding the temperature measurement wafer 1. Thereafter, the substrate conveyance mechanism TR3 horizontally moves in the x direction to convey the temperature measurement wafer 1 to the load/unload port 60A in the predetermined thermal processing unit 43. FIG. 21 illustrates a state in which the temperature measurement wafer 1 is conveyed from the standby unit 45 to the load/unload port 60A of the thermal processing unit 43B.

As illustrated in FIG. 21, after the temperature measurement wafer 1 is conveyed, the temperature measurement wafer 1 is loaded into the thermal processing unit 43B via the load/unload port 60A of the thermal processing unit 43B and placed on the heating plate 54. The step of loading the temperature measurement wafer 1 into the thermal processing unit 43 and placing the temperature measurement wafer 1 onto the heating plate 54 is as described above with reference to FIGS. 13A to 13D and FIGS. 14A to 14B, and thus description thereof is omitted. In a state where the rotation of the temperature measurement wafer 1 is appropriately adjusted in step S7, the temperature measurement wafer 1 is placed on the heating plate 54 of the thermal processing unit 43B. Thus, in the temperature measurement wafer 1 placed on the heating plate 54 of the thermal processing unit 43B, the orientation of the measurement substrate 5 is as illustrated in FIG. 17.

After the temperature measurement wafer 1 is placed on the heating plate 54 of the thermal processing unit 43B and step S2 is completed, the temperature of the heating plate 54 of the thermal processing unit 43B is measured (step S3). The temperature data of the heating plate 54 is transmitted from the transmission unit 8 of the temperature measurement wafer 1 to the receiving unit 46 of the substrate processing apparatus 30 in a wireless manner, and is further transmitted to the control unit 85 (step S4). The control unit 85 adjusts the temperature of the heating plate 54 of the thermal processing unit 43B based on the received temperature data (step S5).

After steps S2 to S5 are completed for the heating plate 54 of the thermal processing unit 43B, steps S2 to S5 are repeated in the same manner for the other four thermal processing units 43B arranged in parallel in the z direction. For each of the five thermal processing units 43B, when wireless communication is performed from the transmission unit 8 to the receiving unit 46 on the heating plate 54, the optimum orientations of the measurement substrates 5 are all the same. Thus, it is not necessary to change the orientation of the temperature measurement wafer 1 while steps S2 to S5 are repeatedly performed on the heating plates 54 included in the five thermal processing units 43B.

However, when steps S2 to S5 are completed for the five thermal processing units 43B, next, an operation such as temperature measurement is performed on the heating plate 54 of the thermal processing units 43C. The positional relationship between the thermal processing units 43B and the receiving unit 46 in plan view is different from the positional relationship between the thermal processing units 43C and the receiving unit 46. That is, the orientation of the measurement substrate 5 suitable for performing wireless communication on the heating plate 54 of the thermal processing unit 43B is different from the orientation of the measurement substrate 5 suitable for performing wireless communication on the heating plate 54 of the thermal processing unit 43C.

Thus, after steps S2 to S5 are performed on the thermal processing unit 43B and before steps S2 to S5 are performed on the thermal processing unit 43C, it is preferable to execute steps S6 to S7 to adjust the orientation of the measurement substrate 5 to a direction suitable for the thermal processing unit 43C.

That is, after steps S2 to S5 are performed for all the thermal processing units 43B, the temperature measurement wafer 1 is conveyed from the thermal processing unit 43B to the standby unit 45 (step S6). Then, in a state where the temperature measurement wafer 1 is held by the hold rotation unit 76 of the standby unit 45, the control unit 85 rotates the hold rotation unit 76 around the axis in the z direction (step S7). By rotating the hold rotation unit 76 at an appropriate angle, the orientation of the measurement substrate 5 in the temperature measurement wafer 1 is adjusted to the direction suitable for the thermal processing unit 43 C.

After step S7 is completed, the processing returns to step S2. That is, the process of conveying the temperature measurement wafer 1 from the standby unit 45 to the thermal processing unit 43C starts. The substrate conveyance mechanism TR3 holds the temperature measurement wafer 1 and conveys the temperature measurement wafer 1 to the load/unload port 60A of the thermal processing unit 43C. The temperature measurement wafer 1 is loaded into the thermal processing unit 43C via the load/unload port 60A and placed on the heating plate 54 of the thermal processing unit 43C (step S2).

FIG. 22 illustrates a state in which the temperature measurement wafer 1 in which the orientation of the measurement substrate 5 is adjusted to the direction suitable for the thermal processing unit 43C is placed on the heating plate 54 of the thermal processing unit 43C. In this case, the distance T3 from the measurement substrate 5 to the receiving unit 46 is minimized. In the state of FIG. 22, the standby unit 45 is lifted or lowered in the z direction to avoid interference between the standby unit 45 and the substrate conveyance mechanism TR3.

After the temperature measurement wafer 1 is placed on the heating plate 54 of the thermal processing unit 43C and step S2 is completed, the temperature of the heating plate 54 of the thermal processing unit 43C is measured (step S3). The temperature data of the heating plate 54 is transmitted from the transmission unit 8 of the temperature measurement wafer 1 to the receiving unit 46 of the substrate processing apparatus 30 in a wireless manner, and is further transmitted to the control unit 85 (step S4). The control unit 85 adjusts the temperature of the heating plate 54 of the thermal processing unit 43C based on the received temperature data (step S5).

In this manner, the substrate processing unit 100 according to Example 1 is configured to appropriately adjust the orientation of the measurement substrate 5 by performing step S6 and step S7 to change the orientation of the measurement substrate 5 in the temperature measurement wafer 1.

### (C) When Charging is Performed on Temperature Measurement Wafer

Next, a case where the selection in step Q2 is "Yes" will be described. When the selection in step Q2 is "Yes", steps S8 and S9 are performed after step S5 is completed. Here, it is assumed that all the selections of steps Q1, Q3, and Q4 are "No".

While steps S2 to S5 are repeated for the plurality of thermal processing units 43, the power stored in the all-solid-state secondary battery 21 included in the battery substrate 7 gradually decreases. To avoid the temperature measurement wafer 1 from not operating because of depletion of the accumulated power of the all-solid-state secondary battery 21, a charging operation for supplying power to the all-solid-state secondary battery 21 at a predetermined timing is required.

In the substrate processing system 100 according to Example 1, the standby unit 45 disposed inside the substrate processing apparatus 30 is configured to be able to perform a charging operation on the temperature measurement wafer 1. That is, the fact that the power remaining in the all-solid-state secondary battery 21 has a value equal to or less than the predetermined value F1 triggers steps S8 and S9, and charging is performed on the temperature measurement wafer 1.

Hereinafter, step S8 and step S9 performed when the selection of step Q2 is "Yes" will be described.

### Step S8 (Conveyance to standby unit)

A signal indicating the remaining power amount of the all-solid-state secondary battery 21 of the temperature measurement wafer 1 is transmitted to the A/D converter 6 as needed. Then, the signal is digitally converted by the A/D converter 6, whereby data indicating the remaining power amount of the all-solid-state secondary battery 21 is acquired. The data of the remaining power amount is wirelessly transmitted from the transmission unit 8 to the receiving unit 46 and further transmitted to the control unit 85. By comparing the data of the remaining power amount of the all-solid-state secondary battery 21 with the predetermined value F1 stored in the storage unit 89, the control unit 85 can quickly determine that the remaining power amount of the all-solid-state secondary battery 21 is consumed to a value equal to or less than the predetermined value F1.

When the remaining power amount of the all-solid-state secondary battery 21 has a value equal to or less than the predetermined value F1, step S8 is started, and the temperature measurement wafer 1 is conveyed to the standby unit 45. Step S8 is common to step S6. That is, the substrate conveyance mechanism TR3 moves to the standby unit 45 while holding the temperature measurement wafer 1. Then, the spin chuck 81 of the hold rotation unit 76 sucks and holds the back surface side of the temperature measurement wafer 1, whereby the temperature measurement wafer 1 is placed and held on the hold rotation unit 76 of the standby unit 45 (see FIG. 19).

### Step S9 (Charging of wafer)

After the temperature measurement wafer 1 is conveyed to the standby unit 45 and held by the hold rotation unit 76, charging is performed on the temperature measurement wafer 1. That is, in a state where the temperature measurement wafer 1 is placed and held on the spin chuck 81, the control unit 85 controls the power feeding unit 80 to supply power from the power feeding unit 80 to the power receiving unit 13 of the power receiving substrate 9 (see FIG. 3). As illustrated in FIG. 23, the power feeding unit 80 is embedded in the spin chuck 81 of the hold rotation unit 76. Thus, when the temperature measurement wafer 1 is placed onto the hold rotation unit 76, the power feeding unit 80 comes close to the power receiving substrate 9. Thus, power EL can be more efficiently supplied from the power feeding unit 80 to the power receiving substrate 9.

The power EL supplied from the power feeding unit 80 to the power receiving unit 13 of the power receiving substrate 9 is transmitted from the power receiving substrate 9 to the battery substrate 7, and is further supplied to the all-solid-state secondary battery 21 of the battery substrate 7. By operating the power feeding unit 80 in a state where the temperature measurement wafer 1 is placed on the hold rotation unit 76 in this manner, the power EL is accumulated in the all-solid-state secondary battery 21 of the temperature measurement wafer 1, and charging is completed.

After the charging of the temperature measurement wafer 1 is completed, the operation of performing steps S2 to S5 on the heating plate 54 of the thermal processing unit 43 is resumed. That is, the control unit 85 controls the substrate conveyance mechanism TR3 and the like to convey the temperature measurement wafer 1 from the standby unit 45 to the thermal processing unit 43 with the substrate conveyance mechanism TR3 (step S2). Then, in a state the temperature measurement wafer 1 is placed on the heating plate 54 of the thermal processing unit 43, the temperature of the heating plate 54 is measured to adjust the temperature. (steps S3 to S5).

In this manner, the substrate processing unit 100 according to Example 1 is configured to be able to charge the temperature measurement wafer 1 by performing steps S8 and S9 when the remaining power amount of the all-solid-state secondary battery 21 in the temperature measurement wafer 1 has a value equal to or less than the predetermined value F1. In Example 1, by disposing the power feeding unit 80 in the standby unit 45, the temperature measurement wafer 1 can be charged without unloading the temperature measurement wafer 1 to the outside of the substrate processing apparatus 30. Thus, the operation efficiency of the temperature measurement wafer 1 can further improve.

### (D) When temperature of temperature measurement wafer has increased

Next, a case where the selection in step Q3 is "Yes" will be described. When the selection in step Q3 is "Yes", steps S10 and S11 are performed after step S5 is completed. Here, it is assumed that all the selections of steps Q1, Q2, and Q4 are "No".

When steps S2 to S5 are repeated for the plurality of thermal processing units 43, the temperature of the temperature measurement wafer 1 increases. In particular, by placing the temperature measurement wafer 1 on the heating plate 54 in a high temperature state, the temperature of the temperature measurement wafer 1 is likely to increase. When the temperature of the temperature measurement wafer 1 has excessively increased, the operation efficiency of the temperature measurement wafer 1 degrades. In particular, when the temperatures of the battery substrate 7 and the power receiving substrate 9 has excessively increased, the all-solid-state secondary battery 21 and various integrated circuits deteriorate, and thus, the performance of the temperature measurement wafer 1 is likely to degrade.

Thus, the substrate processing system 100 according to Example 1 is configured to detect the temperatures of the battery substrate 7 and the power receiving substrate 9 disposed on the temperature measurement wafer 1 as needed. The substrate processing system 100 is configured to cool the temperature measurement wafer 1 (step S10) and notify information indicating that the battery substrate 7 or the power receiving substrate 9 has a high temperature (step S11) when either the temperature of the battery substrate 7 or the temperature of the power receiving substrate 9 has a value equal to or more than the operation threshold F2.

Hereinafter, step S10 and step S11 performed when the selection of step Q3 is "Yes" will be described.

### Step S10 (Cooling of wafer)

When the temperature of either the battery substrate 7 or the power receiving substrate 9 has a value equal to or more than the operation threshold F2, the control unit 85 controls various configurations to cool the temperature measurement wafer 1. A situation in which the temperatures of the battery substrate 7 and the power receiving substrate 9 have values equal to or more than the operation threshold F2 occurs in most cases when the temperature measurement wafer 1 is placed on the heating plate 54. Thus, when the selection in step Q3 is "Yes", the cooling control unit 88 included in the control unit 85 conveys the temperature measurement wafer 1 from the heating plate 54 to the cooling plate 53, and executes the cooling processing on the cooling plate 53.

An operation of conveying the temperature measurement wafer 1 from the heating plate 54 to the cooling plate 53 will be described with reference to FIGS. 24A to 24C.

See FIG. 24A. When the cover 68 is lowered from an upper retracting position, the cover lifting mechanism 69 lifts the cover 68 to the retracting position. Thereafter, the second pin lifting mechanism 58 lifts the three second support pins 57 to place the temperature measurement wafer 1 onto the three second support pins 57.

See FIG. 24B. The local conveyance mechanism 59 moves the conveyance arm 65 holding the temperature measurement wafer 1 from above the heating plate 54 to above the cooling plate 53.

See FIG. 24C. The local conveyance mechanism 59 lowers the conveyance arm 65 to bring the conveyance arm into contact with the cooling plate 53. When the conveyance arm 65 comes into contact with the cooling plate 53, the conveyance arm 65 is cooled by the cooling plate 53. That is, the temperature measurement wafer 1 held by the conveyance arm 65 is cooled by the cooling plate 53 together with the conveyance arm 65. Through the cooling processing with the cooling plate 53, the temperature of the battery substrate 7 and the temperature of the power receiving substrate 9 in the temperature measurement wafer 1 decrease. As a result, both the temperature of the battery substrate 7 and the temperature of the power receiving substrate 9 quickly have values less than the operation threshold F2.

### Step S11 (Notification of temperature increase)

In Example 1, step S11 is performed in parallel with the step according to step S10. When step S11 is started, the control unit 85 activates the notification unit 91. The notification unit 91 generates a warning sound, light, or the like to notify the operator of information indicating that the temperature of the battery substrate 7 or the power receiving substrate 9 has increased to a value equal to more than the operation threshold F2. As another example of the configuration in which the notification unit 91 notifies the information on the temperature increase, characters or images suggesting that the temperature of the battery substrate 7 or the power receiving substrate 9 has increased to a value equal to or more than the operation threshold F2 may be displayed on the display unit included in the operation unit 87.

The notification unit 91 notifies the information on the temperature increase, and thus the operator can quickly know that the temperature of the battery substrate 7 or the power receiving substrate 9 has increased to a value equal to or more than the operation threshold F2. When the operator has obtained the information from the notification unit 91, the operator executes, as an example, an operation of unloading the temperature measurement wafer 1 to the outside of the substrate processing apparatus 30, collects the temperature measurement wafer 1 whose temperature has increased, and loads a new temperature measurement wafer 1 into the substrate processing apparatus 30.

In this manner, the substrate processing unit 100 according to Example 1 is configured to perform step S10 and step S11 when the temperature of the battery substrate 7 or the power receiving substrate 9 in the temperature measurement wafer 1 has increased to a value equal to or more than the operation threshold F2. By performing steps S10 and S11, the temperature of the temperature measurement wafer 1 can be quickly lowered even when the temperature of the temperature measurement wafer 1 has increased to a value equal to or more than the operation threshold F2. As a result, it is possible to more reliably avoid a situation in which the performance of the temperature measurement wafer 1 deteriorates because of an increase in the temperature of the temperature measurement wafer 1 to a value equal to or more than the operation threshold F2.

### (E) When Temperature Measurement is Completed for All Heating Plates 54

Finally, a case where the selection in step Q4 is "Yes" will be described. When steps S2 to S5 have been completed for all the thermal processing units 43 selected as the subject for measuring temperature, the selection of step Q4 is "Yes". In this case, the control unit 85 controls the substrate conveyance mechanisms TR1 to TR3 to convey the temperature measurement wafer 1 to the outside of the substrate processing apparatus 30. That is, the substrate conveyance mechanism TR3 holds and unloads the temperature measurement wafer 1 from the holding block 32 and conveys the temperature measurement wafer 1 to the substrate placement unit PS1 of the indexer block 31. The substrate conveyance mechanism TR1 holds the temperature measurement wafer 1 placed on the substrate placement unit PS1 and conveys the temperature measurement wafer 1 to the outside of the indexer block 31 through the opening 91. Then, the substrate conveyance mechanism TR1 loads the temperature measurement wafer 1 into the carrier C. The operator collects the temperature measurement wafer 1 loaded into the carrier C. Through the above steps, a series of operations is completed.

When the selection in step Q4 is "Yes", a series of operations may be completed in a state where the temperature measurement wafer 1 is waiting in the standby unit 45. That is, when the selection in step Q4 is "Yes", the substrate conveyance mechanism TR3 holds the temperature measurement wafer 1 and conveys the temperature measurement wafer 1 to the standby unit 45. Then, in a state where the temperature measurement wafer 1 is placed and held by the hold rotation unit 76 of the standby unit 45, the temperature measurement wafer 1 is caused to wait until the step of measuring the thermal processing unit 43 starts again.

### <Effects of Configuration of Example 1>

The substrate measurement unit 100 according to Example 1 includes the temperature measurement wafer 1 and the substrate processing apparatus 30. The temperature measurement wafer 1 measures the temperature of the heating plate 54 included in the thermal processing unit 43. The temperature measurement wafer 1 includes the temperature sensor 3, the transmission unit 8, and the battery substrate 7. The temperature sensor 3 measures the temperature of the heating plate 54 in a state where the temperature measurement wafer 1 is placed on the heating plate 54 that is a temperature measurement subject.

The transmission unit 8 wirelessly transmits temperature data of the heating plate measured by the temperature sensor 3 to the outside of the temperature measurement wafer 1 in a state where the temperature measurement wafer 1 is placed on the heating plate 54. The temperature data transmitted from the transmission unit 8 is received by the receiving unit 46 included in the substrate processing apparatus 30. That is, the substrate measurement unit 100 is configured to perform wireless communication between the temperature measurement wafer 1 and the substrate processing apparatus 30.

Since the temperature measurement wafer 1 includes the transmission unit 8, a communication wire is unnecessary. That is, the temperature measurement wafer 1 can be operated in a wireless manner. In a wired temperature measurement wafer using a communication wire, the range in which the temperature measurement wafer can be conveyed is limited to the length of the communication wire, and thus, the versatility of the temperature measurement wafer is lowered. In addition, there is also a concern that the communication wire is twisted or disconnected when the wired temperature measurement wafer is conveyed, and it becomes difficult to externally communicate information from the temperature measurement wafer. Further, it is difficult to automate the step of loading the wired temperature measurement wafer into the substrate processing apparatus, and it is necessary to manually load the temperature measurement wafer into the substrate processing apparatus. Unlike such a conventional temperature measurement wafer, in Example 1, the temperature measurement wafer 1 is operated in a wireless manner, and thus, it is possible to avoid a decrease in operation efficiency caused by a communication wire. Thus, the operation efficiency of the temperature measurement wafer 1 can be improved.

The battery substrate 7 includes the all-solid-state secondary battery 21. That is, the battery substrate 7 supplies power to the temperature sensor 3, the transmission unit 8, and the like using the all-solid-state secondary battery 21. In Example 1, by mounting the all-solid-state secondary battery 21 as a power source on the temperature measurement wafer 1, the temperature measurement wafer 1 can be operated under a higher temperature condition as compared with a conventional wireless temperature measurement wafer on which an alkali ion battery or the like is mounted. Specifically, in the conventional wireless temperature measurement wafer, the temperature of the heating plate 54 capable of performing temperature measurement is limited to 150°C or less. On the other hand, in Example 1, by using the all-solid-state secondary battery 21, the temperature of the heating plate 54 heated to about 250°C can be measured. Thus, it is possible to use the temperature measurement wafer 1 under a higher temperature condition while improving the operation efficiency of the temperature measurement wafer 1.

In the battery substrate 7, the all-solid-state secondary battery 21 has a flat shape. In this case, because the thickness of the temperature measurement wafer 1 on which the battery substrate 7 is disposed can be reduced, the temperature measurement wafer 1 can be automatically conveyed using the substrate conveyance mechanisms TR1 to TR3 in the same manner as the wafer W. Specifically, since the thermal processing units 43 tend to be stacked in more multiple rows in the substrate processing apparatus 30, the slit width (width in the z direction) of the load/unload port 60A of the thermal processing unit 43 tends to decrease. Thus, to realize a configuration in which the substrate conveyance mechanism TR3 automatically conveys the temperature measurement wafer 1 via the load/unload port 60A of the thermal processing unit 43, the thickness of the temperature measurement wafer 1 is required to be 4 mm or less over the entire wafer. Conventionally, it has been difficult to downsize the all-solid-state secondary battery or the like, and thus, it has been difficult to reduce the thickness of the temperature measurement wafer on which the all-solid-state secondary battery is mounted to such an extent that the temperature measurement wafer can be automatically conveyed.

In Example 1, the all-solid-state secondary battery 21 has a flat shape. As an example, a plurality of all-solid-state secondary batteries 21 are disposed along the surface of the wafer body 2 in a state of being electrically connected in series. Thus, the battery substrate 7 can be thinned while increasing the capacity of the battery substrate 7. Thus, the temperature measurement wafer 1 on which the all-solid-state secondary battery 21 is mounted can be automatically conveyed, and thus, the heat resistance and the operation efficiency of the temperature measurement wafer 1 can be improved. In particular, the battery substrate 7 has a structure in which the heat insulating sheet 15, the lower plate 17b of the housing 17, the tape 27, the heat insulating sheet 23, the battery unit 19, the heat insulating sheet 25, and the tape 29 are stacked in order from the side closer to the wafer body 2 in the thickness direction. With such a structure, it is possible to reduce the thickness d of the battery substrate 7 including the portion of the wafer body 2 to 4 mm or less while improving the heat resistance of the battery substrate 7. That is, by having such a stack structure in which the all-solid-state secondary battery 21 is sandwiched between a plurality of heat insulating sheets, the thickness of the battery substrate 7 including the all-solid-state secondary battery 21 can be reduced while improving the heat resistance of the battery substrate 7.

Further, in the substrate processing system 100 according to Example 1, it is possible to improve the accuracy of the temperature adjustment of the heating plate 54 and to quickly execute the temperature adjustment. In a conventional temperature measurement wafer, a memory is mounted as shown in JP 2006-080489 A, and temperature data of a heating plate is stored in the memory after the temperature of the heating plate is measured. Then, after the temperature data of a plurality of heating plates is stored in the memory, the temperature measurement wafer is unloaded from the heating plate and conveyed to a data reading unit, and all the temperature data is read from the memory. Then, the temperature of each heating plate is adjusted using each read temperature data.

In such a conventional configuration, temperature data cannot be read until the temperatures of all the heating plates are measured. Thus, it is difficult to quickly adjust the temperature of the heating plate. In addition, in the conventional configuration, the temperature measurement wafer is unloaded from the heating plate at the time of reading the temperature data. Thus, even though the temperature is adjusted according to the temperature data, it is difficult to quickly confirm whether the temperature of the heating plate is accurately adjusted to the assumed temperature.

In contrast to such a conventional configuration, in Example 1, the transmission unit 8 transmits temperature data to the outside of the temperature measurement wafer 1 in a state where the temperature measurement wafer 1 is placed on the heating plate 54. That is, immediately after the temperature measurement wafer 1 is placed on the heating plate 54 and the temperature of the heating plate 54 is measured, the transmission unit 8 can transmit the temperature data of the heating plate 54 in real time. Thus, the temperature data of the heating plate 54 can be quickly acquired using the temperature measurement wafer 1. Further, in a state where the temperature measurement wafer 1 is placed on the heating plate 54 that is a temperature measurement subject, a step of acquiring temperature data of the heating plate 54 and a step of adjusting the temperature of the heating plate 54 based on the temperature data are executed. That is, after the step of adjusting the temperature of the heating plate 54 based on the temperature data is executed, the temperature data of the heating plate 54 can be further measured in a state where the temperature measurement wafer 1 is placed on the heating plate 54. Thus, it is possible to quickly confirm whether the heating plate is accurately adjusted to the assumed temperature. As a result, in Example 1, the temperature of the heating plate 54 can be quickly and accurately adjusted.

In such a configuration of Example 1, the temperature data of the heating plate 54 is transmitted in real time, and thus, it is not necessary to dispose an electronic device for storage such as a memory on the temperature measurement wafer 1. Thus, it is possible to avoid a situation in which an electronic device such as a memory malfunctions because of a high temperature. As a result, the heat resistance of the temperature measurement wafer 1 can be improved.

In Example 1, the heat resistance of the temperature measurement wafer 1 is improved by using the all-solid-state secondary battery 21 as a power source. That is, the state in which the temperature measurement wafer 1 is placed on the heating plate 54 can be maintained for a longer time. As a result, in a state where the temperature measurement wafer 1 is placed on the heating plate 54 that is a temperature measurement subject, the step (step S3) of measuring the temperature of the heating plate 54, the step (step S4) of acquiring the temperature data of the heating plate 54, and the step (step S5) of adjusting the temperature of the heating plate 54 based on the temperature data can be repeatedly executed for a longer time. In other words, in Example 1, even though the processes of steps S3 to S5 are repeatedly executed, a situation in which the temperature of the temperature measurement wafer 1 increases and the performance of the temperature measurement wafer 1 lowers hardly occurs. Thus, the operation of adjusting the temperature of the heating plate 54 using the temperature measurement wafer 1 can be performed more quickly and with high accuracy.

In Example 1, the power receiving substrate 9 having the power receiving unit 13 is disposed on the temperature measurement wafer 1. The power receiving substrate 9 receives power supplied from the outside of the temperature measurement wafer 1. The power received by the power receiving substrate 9 is supplied to the all-solid-state secondary battery 21 of the battery substrate 7. That is, the temperature measurement wafer 1 has a configuration in which the all-solid-state secondary battery 21 is charged by power supplied from the outside. Thus, the operating time of the temperature measurement wafer 1 can be extended by supplying power from the outside. Further, the substrate processing apparatus 30 includes the standby unit 45 having the power feeding unit 80. The power feeding unit 80 supplies power to the power receiving unit 13 of the temperature measurement wafer 1. That is, when the power of the temperature measurement wafer 1 has decreased, the temperature measurement wafer 1 is conveyed to the standby unit 45, and thus, the power feeding unit 80 can charge the temperature measurement wafer 1. In this case, the battery substrate 7 can be charged without unloading the temperature measurement wafer 1 to the outside of the substrate processing apparatus 30. Thus, the temperature measurement wafer 1 can be operated for a longer period of time while improving the operation efficiency of the temperature measurement wafer 1.

The standby unit 45 is provided with the hold rotation unit 76 that is rotatable around an axis in the z direction. The hold rotation unit 76 can change the direction of the temperature measurement wafer 1 around the axis in the z direction by rotating while holding the temperature measurement wafer 1. The measurement substrate 5 including the transmission unit 8 is disposed on the outer peripheral part of the temperature measurement wafer 1. By changing the direction of the temperature measurement wafer 1, the orientation of the transmission unit 8 is changed in the horizontal direction (x direction and y direction) orthogonal to the z direction.

That is, by conveying the temperature measurement wafer 1 to the standby unit 45, the temperature measurement wafer 1 can be adjusted such that the orientation of the transmission unit 8 faces the receiving unit 46. That is, even when the substrate processing apparatus 30 has a configuration in which a plurality of heating plates 54 are arranged in parallel in the x direction or the y direction, the temperature measurement wafer 1 can be adjusted in an optimum direction such that the orientation of the transmission unit 8 faces the receiving unit 46 on each heating plate 54. Thus, even when the temperature measurement wafer 1 is placed on any heating plate 54, wireless communication from the transmission unit 8 of the temperature measurement wafer 1 to the receiving unit 46 of the substrate processing apparatus 30 can be accurately executed.

In Example 1, the standby unit 45 is disposed in the conveyance space 42. The substrate conveyance mechanism TR3 that conveys the temperature measurement wafer 1 between a plurality of heating plates 54 is disposed in the conveyance space 42. Thus, when a situation has occurred in which the temperature measurement wafer 1 is caused to wait in the standby unit 45 at the timing of conveying the temperature measurement wafer 1 from one heating plate 54 to another heating plate 54, the temperature measurement wafer 1 can be quickly conveyed to the standby unit 45. Thus, the operation efficiency of the substrate processing system 100 can be further improved.

In Example 1, the temperature measurement wafer 1 includes the battery temperature detection unit 11 and the substrate temperature detection unit 14. The battery temperature detection unit 11 measures the temperature of the battery substrate 7 and transmits the temperature data of the battery substrate 7 to the transmission unit 8. The substrate temperature detection unit 14 measures the temperature of the power receiving substrate 9 and transmits the temperature data of the power receiving substrate 9 to the transmission unit 8. The transmission unit 8 is configured to wirelessly transmit the temperature data of the battery substrate 7 and the temperature data of the power receiving substrate 9 to the receiving unit 46. That is, the temperature measurement wafer 1 can transmit not only the temperature data of the heating plate 54 but also the temperature data of the battery substrate 7 and the temperature data of the power receiving substrate 9 to the outside of the temperature measurement wafer 1.

Each of the temperature data received by the receiving unit 46 is transmitted to the control unit 85. When the temperature of either the battery substrate 7 or the power receiving substrate 9 has a value equal to or more than the operation threshold F2 based on the received temperature data, the control unit 85 controls each unit of the substrate processing apparatus 30 so as to avoid heating of the temperature measurement wafer 1. Examples of control for avoiding heating of the temperature measurement wafer 1 include control for retracting the temperature measurement wafer 1 from the heating plate 54 and cooling the temperature measurement wafer 1 on the cooling plate 53. In Example 1, by providing the configuration for measuring the temperatures of the battery substrate 7 and the power receiving substrate 9, a situation in which the temperature measurement wafer 1 is excessively heated and the performance is degraded can be quickly and reliably avoided.

Further, in Example 1, the substrate processing apparatus 30 includes the notification unit 91. When the temperature of either the battery substrate 7 or the power receiving substrate 9 becomes equal to or higher than the operation threshold F2, the notification unit 91 notifies the operator of the information. Since the operator can quickly know from the notification unit 91 that the temperature of either the battery substrate 7 or the power receiving substrate 9 has a value equal to or more than the operation threshold F2, the operator can quickly execute an operation for avoiding an increase in temperature of the temperature measurement wafer 1. Thus, it is possible to more reliably avoid deterioration of the performance of the temperature measurement wafer 1 because of heating of the battery substrate 7 or the power receiving substrate 9 to a temperature having a value equal to or more than the operation threshold F2.

### Example 2

Next, Example 2 of the present invention will be described with reference to the drawings. The same reference signs are given to the same configurations as those of Example 1, and a detailed description thereof will be omitted. A substrate processing system 100A according to Example 2 includes the temperature measurement wafer 1 and a substrate processing apparatus 30A. FIG. 26 is a longitudinal sectional view illustrating the substrate processing apparatus 30A according to Example 2. FIG. 27 is a transverse sectional view illustrating the substrate processing apparatus 30A according to Example 2. FIG. 27 corresponds to a sectional view taken along arrows c-c in FIG. 26.

The substrate processing apparatus 30A according to Example 2 is different from the substrate processing apparatus 30 according to Example 1 in the position where the standby unit 45 is disposed. As illustrated in FIG. 4 and the like, in the substrate processing apparatus 30 according to Example 1, the standby unit 45 is disposed in the conveyance space 42 of the processing block 32. On the other hand, in the substrate processing apparatus 30A according to Example 2, as illustrated in FIGS. 26 and 27, the standby unit 45 is disposed in a thermal processing block unit 97 of the processing block 32.

FIG. 26 illustrates a disposition of the thermal processing unit 43 and the standby unit 45 in the processing block 32. In Example 2, as in Example 1, spaces in which the thermal processing units 43 can be disposed are provided in 3 columns × 5 rows in the thermal processing block unit 97. In Example 2, the standby units 45 are disposed in any of the spaces provided in 3 columns × 5 rows. In FIG. 26, as an example, the standby unit 45 is disposed at the lowermost row of the column in which the thermal processing unit 43C is provided. That is, in Example 2, each of a thermal processing block unit 97A and a thermal processing block unit 97B includes five thermal processing units 43A, five thermal processing units 43B, and four thermal processing units 43C. In the substrate processing apparatus 30A according to Example 2, the standby unit 45 is disposed in the empty space of the thermal processing block 97 like this.

FIG. 27 illustrates a state in which the temperature measurement wafer 1 is being conveyed from the thermal processing unit 43A to the standby unit 45 in Example 2. That is, FIG. 27 illustrates the operation of step S6 (or step S8) according to Example 2. When the temperature measurement wafer 1 is conveyed from the thermal processing unit 43A to the standby unit 45 in Example 2, the substrate processing mechanism TR3 holds the temperature measurement wafer 1 in the thermal processing unit 43A, and then unloads the temperature measurement wafer 1 from the thermal processing unit 43A via the load/unload port 60A of the thermal processing unit 43A (see reference sign PE). Thereafter, as the first moving mechanism 51 moves in the x direction, the substrate processing mechanism TR3 conveys the temperature measurement wafer 1 to the load/unload port 60A of the standby unit 45. Then, the substrate processing mechanism TR3 loads the temperature measurement wafer 1 into the standby unit 45 via the load/unload port 60A, and places the temperature measurement wafer 1 onto the hold rotation unit 76. Since steps S1 to S11 according to Example 2 are the same as those of Example 1, detailed description thereof will be omitted.

In Example 2, as in Example 1, the temperature of the heating plate 54 is measured using the temperature measurement wafer 1. The substrate processing apparatus 30A according to Example 2 has the same configuration as the substrate processing apparatus 30 according to Example 1 except for the position of the standby unit 45. Thus, in Example 2, the same effects as those of Example 1 can be obtained. That is, it is possible to use the temperature measurement wafer 1 under a higher temperature condition while improving the operation efficiency of the substrate processing unit 100A.

In Example 2, the standby unit 45 is disposed in an empty space of the thermal processing block 97. In this case, for the conventional substrate processing apparatus, the substrate processing apparatus 30A according to Example 2 can be easily realized by replacing any of the plurality of thermal processing units 43 disposed in the thermal processing block 97 with the standby unit 45. That is, by using an existing substrate processing apparatus, the effect of the substrate processing unit 100A according to the present invention can be obtained at low cost. In Example 2, the standby unit 45 is disposed in the thermal processing block 97. Thus, it is possible to reliably avoid interference between the substrate conveyance mechanism TR3 disposed in the conveyance space 42 and the standby unit 45.

### Example 3

Next, Example 3 of the present invention will be described with reference to the drawings. A substrate processing system 100B according to Example 3 includes the temperature measurement wafer 1 and a substrate processing apparatus 30B. FIG. 28 is a plan view of the substrate processing apparatus 30B according to Example 3. FIG. 28 is a longitudinal sectional view of the substrate processing apparatus 30B according to Example 3. The substrate processing apparatus 30B according to Example 3 includes a processing block 98, an interface block 99, and an exposure device EXP in addition to the indexer block 31 and the processing block 32. The configurations of the indexer block 31 and the processing block 32 are the same as those of Example 1, and thus the description thereof will be omitted.

The processing block 98 performs development processing on the wafer W that has been exposed. The processing block 98 includes a thermal processing block 101, a conveyance space 102, and a development block 103. The processing block 98 includes a processing layer 98A on the upper side and a processing layer 98B on the lower side. Each of the upper processing layer 98A and the lower processing layer 98B includes one thermal processing block 101, one conveyance space 102, and one development block 103. The thermal processing block 101 and the development block 103 are disposed so as to sandwich the conveyance space 102.

The thermal processing block 101 includes an edge exposure unit EEW and a plurality of thermal processing units 43. The edge exposure unit EEW performs exposure processing on a peripheral part of the wafer W. The edge exposure unit EEW includes a hold rotation unit similar to the hold rotation unit 76. In Example 3, in the same manner as in the thermal processing block 97, the thermal processing block 101 includes 15 thermal processing units 43 arranged in 3 columns × 5 rows.

As illustrated in FIG. 29, the conveyance space 102 includes a substrate conveyance mechanism TR4. The substrate conveyance mechanism TR4 is configured in the same manner as in the substrate conveyance mechanism TR3 included in the conveyance space 42. A substrate placement unit PS3 is provided between the processing layer 32A of the processing block 32 and the processing layer 98A of the processing block 98. A substrate placement unit PS4 is provided between the processing layer 32B of the processing block 32 and the processing layer 98B of the processing block 98. That is, the substrate placement unit PS3 and the substrate placement unit PS4 are disposed between the processing block 32 and the processing block 98. A substrate placement unit PS5 is provided between the upper processing layer 98A and the interface block 99. A substrate placement unit PS6 is provided between the lower processing layer 98B and the interface block 99. In Example 3, the substrate conveyance mechanism TR3, the substrate conveyance mechanism TR4, and the local conveyance mechanism 59 are used to convey the temperature measurement wafer 1 between the heating plate 54 and the standby unit 45. In Example 3, the substrate conveyance mechanism TR3, the substrate conveyance mechanism TR4, and the local conveyance mechanism 59 correspond to a conveyance unit in the present invention.

The development block 103 performs development processing on the wafer W that has been exposed. The development block 103 includes various mechanisms used for developing processing, such as a developing tank filled with a developing solution and a nozzle for applying the developing solution to the wafer W.

The interface block 99 loads and unloads the wafer W with respect to the exposure device EXP that performs the exposure processing. The interface block 99 includes three substrate conveyance mechanisms TR5 to TR7, a plurality of pre-exposure cleaning units 104, a plurality of post-exposure cleaning units SOAK, three placement/cooling units P-CP, a substrate placement unit PS9, and a plurality of thermal processing units 43.

The substrate conveyance mechanism TR5 and the substrate conveyance mechanism TR6 are arranged side by side in the y direction. The substrate conveyance mechanism TR7 is disposed on the right side of the substrate conveyance mechanisms TR5 and TR6 in the x direction. The three substrate conveyance mechanisms TR5 to TR7 are configured in the same manner as the substrate conveyance mechanism TR1.

The pre-exposure cleaning units 104 and the post-exposure cleaning units SOAK are provided so as to face each other with the two substrate conveyance mechanisms TR5 and TR6 interposed therebetween. Each of the cleaning units 104 and SOAK includes a hold rotation unit that holds the wafer W, and a nozzle that discharges a cleaning liquid to the wafer W, for example. The hold rotation unit is configured in the same manner as the hold rotation unit 76 of the standby unit 45. The pre-processing cleaning unit 104 may perform polishing processing on the back surface and the end portion (bevel portion) of the wafer W using a brush or the like. The back surface of the wafer W corresponds to, for example, the surface opposite to the surface on which a circuit pattern is formed.

Three placement/cooling units P-CP and a substrate placement unit PS9 are provided between the three substrate conveyance mechanisms TR5 to TR7. In the interface block 99, six thermal processing units 43 are provided on each of the substrate conveyance mechanism TR5 side and the substrate conveyance mechanism TR6 side. The six thermal processing units 43 are stacked and arranged side by side in the z direction.

The exposure device EXP is an external device that performs exposure processing on the wafer W. The exposure device EXP is disposed adjacent to the interface block 99. In this manner, the substrate processing apparatus 30B according to Example 3 is configured to perform the development processing, the coating processing, the thermal processing, and the exposure processing on the wafer W.

In Example 3, one standby unit 45 is disposed above the substrate placement unit PS3, and one standby unit is disposed above the substrate placement unit PS4. That is, in the substrate processing apparatus 30B according to Example 3, the standby unit 45 is disposed between the processing block 32 and the processing block 98.

In the substrate processing unit 100B according to Example 3, the overview of the step of measuring the temperature of the heating plate 54 using the temperature measurement wafer 1 is the same as the step of Example 1 illustrated in FIG. 11.

When the heating plate 54 of the thermal processing unit 43 disposed in the processing block 98 is measured, the step of conveying the temperature measurement wafer 1 to the thermal processing unit 43 of the processing block 98 in step S2 is as follows. That is, the temperature measurement wafer 1 placed on the substrate placement unit PS1 (or the substrate placement unit PS2) of the indexer block 31 is held by the substrate conveyance mechanism TR3 of the processing block 32. The substrate conveyance mechanism TR3 moves in the x direction while holding the temperature measurement wafer 1, and places the temperature measurement wafer 1 onto the substrate placement unit PS3 (or the substrate placement unit PS4).

The substrate conveyance mechanism TR4 of the processing block 98 holds the wafer body 2 of the temperature measurement wafer 1 placed on the substrate placement unit PS3 (or the substrate placement unit PS4) with the hand 47. Then, the temperature measurement wafer 1 is conveyed from the substrate placement unit PS3 to the thermal processing unit 43 of the processing block 98. Then, in step S3, the temperature measurement wafer 1 is loaded into the thermal processing unit 43, and temperature measurement is performed with the temperature measurement wafer 1 being placed on the heating plate 54.

When the heating plate 54 of the thermal processing unit 43 disposed in the interface block 99 is measured, the step of conveying the temperature measurement wafer 1 to the thermal processing unit 43 of the interface block 99 in step S2 is as follows. That is, the temperature measurement wafer 1 placed on the substrate placement unit PS1 (or the substrate placement unit PS2) of the indexer block 31 is held by the substrate conveyance mechanism TR3 of the processing block 32. The substrate conveyance mechanism TR3 moves in the x direction while holding the temperature measurement wafer 1, and places the temperature measurement wafer 1 onto the substrate placement unit PS3 (or the substrate placement unit PS4).

The substrate conveyance mechanism TR4 of the processing block 98 holds the temperature measurement wafer 1 placed on the substrate placement unit PS3 (or the substrate placement unit PS4). The substrate conveyance mechanism TR4 moves in the x direction while holding the temperature measurement wafer 1, and places the temperature measurement wafer 1 onto the substrate placement unit PS5 (or the substrate placement unit PS6).

The substrate conveyance mechanisms TR5 and TR6 disposed in the interface block 99 hold the temperature measurement wafer 1 placed on the substrate placement unit PS5 with the hand 37. Then, the temperature measurement wafer 1 is conveyed from the substrate placement unit PS5 to the thermal processing unit 43 of the interface block 99. Then, in step S3, the temperature measurement wafer 1 is loaded into the thermal processing unit 43, and temperature measurement is performed with the temperature measurement wafer 1 being placed on the heating plate 54. Steps S3 to S11 in Example 3 are the same as those in Example 1, and thus detailed description thereof will be omitted.

In Example 3, as in Example 1, the temperature of the heating plate 54 is measured using the temperature measurement wafer 1. Also in the substrate processing apparatus 30B that performs the coating processing, the exposure processing, the development processing, and the thermal processing on the wafer W, the same effects as those of Example 1 can be obtained in Example 3 by measuring the temperature of the heating plate 54 using the temperature measurement wafer 1. That is, it is possible to use the temperature measurement wafer 1 under a higher temperature condition while improving the operation efficiency of the substrate processing unit 100B.

In Example 3, the standby unit 45 is disposed between the processing block 32 and the processing block 98. In this case, the standby unit 45 is disposed in the central portion of the substrate processing apparatus 30B in plan view, and thus the time required for conveyance from the thermal processing unit 43 to the standby unit 45 in step S6 or step S8 can be shortened. In Example 3, the standby unit 45 is disposed at a position overlapping the substrate placement unit PS3 in plan view. Thus, by using the operation in which the substrate conveyance mechanism TR3 or the substrate conveyance mechanism TR4 conveys the wafer W at the substrate placement unit PS3, the temperature measurement wafer 1 can be conveyed to the standby unit 45. Thus, it is possible to avoid complication of control for conveying the temperature measurement wafer 1 to the standby unit 45.

The present invention is not limited to the above embodiments, and can be modified as follows.
(1) In each of the above-described examples, the processing block 32 includes the two processing layers 32A and 32B stacked in the z direction, but the present invention is not limited to this configuration. That is, the processing block 32 may have one processing layer or three or more processing layers. Similarly, in Example 3, the processing block 98 may include one or three or more processing layers.
(2) In each of the above-described examples, the substrate processing apparatuses 30, 30A, and 30B are not limited as long as they have a configuration including the thermal processing unit 43, and the configurations of other processing blocks may be appropriately changed. As an example, in the substrate processing apparatus 30 according to Example 1, the processing block 98 that performs development processing may be disposed instead of the processing block 32 that performs coating processing. That is, the substrate processing apparatus 30 may include the indexer block 31 and the processing block 98.
(3) In each of the above-described examples, the number and positions of the standby units 45 disposed in the substrate processing apparatuses 30, 30A, and 30B may be appropriately changed. As an example, the standby unit 45 is not limited to be disposed one by one in each of the processing layer 32A and the processing layer 32B, and may be disposed in one of the processing layer 32A and the processing layer 32B. In addition, each of the processing layer 32A and the processing layer 32B may include two or more standby units 45.
(4) In each of the above-described examples, the substrate processing apparatuses 30, 30A, and 30B do not have to include the standby unit 45. In this case, in the flowchart illustrated in FIG. 11, options Q1 to Q2 and steps S6 to S9 are omitted. In a modification using the substrate processing apparatus 30 including no standby unit 45, charging with respect to the battery substrate 7 using the temperature measurement wafer 1 is performed outside the substrate processing apparatus 30. That is, after the temperature measurement wafer 1 is charged, step S1 is performed. When the remaining power amount in the temperature measurement wafer 1 has a value equal to or less than the predetermined value F1, steps S2 to S5 are interrupted, and the temperature measurement wafer 1 is unloaded to the outside of the substrate processing apparatus 30. Then, the temperature measurement wafer 1 unloaded to the outside of the substrate processing apparatus 30 is charged using a commercial power source or the like. After the charging is completed, the temperature measurement wafer 1 is loaded into the substrate processing apparatus 30 again, and steps S2 to S5 are resumed.
(5) In each of the above-described examples, the operation of conveying the temperature measurement wafer 1 from the heating plate 54 to the cooling plate 53 has been exemplified as a specific operation performed in step S10 of cooling the temperature measurement wafer 1, but the present invention is not limited to this configuration. In step S10, another operation may be performed as long as the operation can avoid the temperature of the temperature measurement wafer 1 from having a value more than the operation threshold F2. As another example of the operation performed in step S10, the temperature of the temperature measurement wafer 1 may be prevented from increasing by conveying the temperature measurement wafer 1 to the standby unit 45 and placing the temperature measurement wafer 1 onto the hold rotation unit 76.
(6) In each of the above-described examples, the power receiving unit 9 included in the temperature measurement wafer 1 is not limited to the configuration that receives power supplied from the outside in a wireless manner. That is, the power receiving unit 9 may be configured to receive external power in a wired manner. As an example, the power receiving unit 9 may include a connection unit to which a power supply cable can be connected, and charge the battery substrate 7 by connecting the power supply cable to the connection unit.
(7) In each of the above-described examples, the position and the number of receiving units 46 that receive the temperature data transmitted from the transmission unit 8 may be appropriately changed. That is, the receiving unit 46 may be disposed in a place other than the conveyance space 42. The substrate processing apparatus 30 does not have to include the receiving unit 46, and the receiving unit 46 may be disposed outside the substrate processing apparatus 30. In a modification in which the substrate processing apparatus 30 include no receiving unit 46, temperature data of the heating plate 54 acquired in a state where the temperature measurement wafer 1 is placed on the heating plate 54 is transmitted from the temperature measurement wafer 1 to the outside of the substrate processing apparatus 30 in a wireless manner. Then, the transmitted temperature data is received by the receiving unit 46 disposed outside the substrate processing apparatus 30.
(8) In each of the above-described examples, as long as information is communicated from the transmission unit 8 of the temperature measurement wafer 1 to the outside of the temperature measurement wafer 1 in a wireless manner, the method for communicating information inside the temperature measurement wafer 1 is not limited to the wireless system. As an example, the temperature sensor 3 and the measurement substrate 5 may be connected by a communication cable, and temperature data may be transmitted from the temperature sensor 3 to the measurement substrate 5 via the communication cable. That is, the communication from the temperature sensor 3 to the measurement substrate 5 may be in a wired manner. Similarly, information may be communicated from the battery substrate 7 to the measurement substrate 5 in a wired manner, or information may be communicated from the power receiving substrate 9 to the measurement substrate 5 in a wired manner.
(9) In each of the above-described examples, the substrate conveyance mechanisms TR3 and TR4 include the two hands 47, but they may include one or three or more hands 47. Similarly, the substrate conveyance mechanisms TR1, TR2, TR5, TR6, and TR7 include the two hands 37, but they may include one or three or more hands 37.
(10) In each of the above-described examples, for example, one end of a gas pipe (not illustrated) may be connected to the cover 68 illustrated in FIG. 4. In this case, any gas can be supplied into the processing space SP surrounded by the heating plate 54 and the cover 68. Examples of the any gas include an inert gas (for example, nitrogen gas) and a processing gas (for example, HMDS (hexamethyldisilazane)).
(11) In each of the above-described examples, the local conveyance mechanism 59 may be omitted. That is, in Examples 1 and 2, the temperature measurement wafer 1 may be conveyed between the heating plate 54 and the standby unit 45 by using only the substrate conveyance mechanism TR3. In such a modification, the substrate conveyance mechanism TR3 conveys the temperature measurement wafer 1 between the standby unit 45 and the cooling plate 53 in the thermal processing unit 43, and conveys the temperature measurement wafer 1 between the cooling plate 53 and the heating plate 54 in the thermal processing unit 43. Similarly, in Example 3, the local conveyance mechanism 59 may be omitted, and the substrate conveyance mechanism TR3 or TR4 may be used to convey the temperature measurement wafer 1 between the heating plate 54 and the standby unit 45.

### Reference Signs List

1: Temperature measurement wafer
2: Wafer body
3: Temperature sensor
5: Measurement substrate
6: A/D converter
7: Battery substrate
8: Transmission unit
9: Power receiving substrate
10: Notch
11: Battery temperature detection unit
13: Power receiving unit
14: Substrate temperature detection unit
15: Heat insulating sheet
17: Housing
19: Battery unit
20: Base substrate
21: All-solid-state secondary battery
23: Heat insulating sheet
25: Heat insulating sheet
27: Tape
29: Tape
30: Substrate processing apparatus
31: Indexer block
32: Processing block
33: Opener
34: Opener
36: Opening
37: Hand
38: Advance/retraction drive unit
39: Rotary drive unit
41: Coating unit
42: Conveyance space
43: Thermal processing unit
45: Standby unit
46: Receiving unit
47: Hand
48: Advance/retraction drive unit
49: Rotary drive unit
51: First moving mechanism
52: Second moving mechanism
53: Cooling plate
54: Heating plate
55: First support pin
56: First pin lifting mechanism
57: Second support pin
58: Second pin lifting mechanism
59: Local conveyance mechanism
60: Casing
61: Hole
63: Lifting member
65: Conveyance arm
66: Hole
67: Lifting member
68: Cover
69: Cover lifting mechanism
71: Exhaust port
73: Arm drive mechanism
74: Proximity ball
75: Slit
76: Hold rotation unit
77: Base unit
78: Notch detection unit
79: Centering mechanism
80: Power feeding unit
81: Spin chuck
83: Rotary drive unit
85: Control unit
86: Temperature control unit
87: Operation unit
88: Cooling control unit
89: Storage unit
91: Notification unit
97: Thermal processing block
98: Processing block
99: Interface block
100: Substrate processing system
C: Carrier
W: Substrate
TR1 to TR7: Substrate conveyance mechanism
PS1 to PS6: Substrate placement unit

## Claims

1. A temperature measurement wafer comprising:
a wafer body that can be placed on a temperature measurement subject;
a plurality of temperature sensors disposed on the wafer body;
a transmission unit capable of wirelessly transmitting temperature data detected by the temperature sensors in a state where the wafer body is placed on the temperature measurement subject; and
a battery unit that is disposed on the wafer body and includes an all-solid-state secondary battery that supplies power to each of the temperature sensors and the transmission unit.

2. The temperature measurement wafer according to claim 1, wherein
the battery unit includes a plurality of the all-solid-state secondary batteries, and
the plurality of all-solid-state secondary batteries are
disposed along a surface of the wafer body in a state of being electrically connected in series.

3. The temperature measurement wafer according to claim 1, further comprising
a power supply unit that supplies power to the battery unit,
the power supply unit including
a wireless power receiving unit capable of receiving power supplied from an outside of the temperature measurement wafer through electromagnetic induction.

4. The temperature measurement wafer according to claim 1, wherein
the battery unit includes:
a first heat insulating sheet disposed on the wafer body; and
a housing unit that is disposed on the first heat insulating sheet and incorporates the all-solid-state secondary battery having a flat shape,
the housing unit includes
a lower surface housing part, a second heat insulating sheet, the all-solid-state secondary battery having a flat shape, a third heat insulating sheet, and an upper surface housing part stacked in this order from a side closer to the first heat insulating sheet.

5. The temperature measurement wafer according to claim 4, wherein the battery unit and the wafer body has a total thickness of 4 mm or less.

6. The temperature measurement wafer according to claim 1, wherein
the transmission unit is
disposed on an outer peripheral part of the wafer body.

7. A substrate processing system comprising: a substrate processing apparatus that performs at least thermal processing on a substrate; and the temperature measurement wafer according to any one of claims 1 to 6,
the substrate processing apparatus including:
a thermal processing unit including a heating plate that is the temperature measurement subject and performs heating processing on the substrate that has been mounted;
a standby unit including a holding unit that holds the temperature measurement wafer, and being configured to allow the temperature measurement wafer held by the holding unit to wait inside the substrate processing apparatus;
a conveyance unit that conveys the temperature measurement wafer between the thermal processing unit and the standby unit; and
a power feeding unit that supplies power to the battery unit of the temperature measurement wafer conveyed to the standby unit.

8. The substrate processing system according to claim 7, further comprising a receiving unit that is disposed outside the thermal processing unit and receives the temperature data wirelessly transmitted from the transmission unit.

9. The substrate processing system according to claim 8, further comprising a rotation mechanism that rotates the temperature measurement wafer conveyed to the standby unit to cause the transmission unit to face the receiving unit when the temperature measurement wafer is mounted on the heating plate.

10. The substrate processing system according to claim 7, wherein
the temperature measurement wafer includes a battery temperature detection unit that detects a temperature of the battery unit,
the transmission unit is configured to wirelessly transmit temperature data of the battery unit detected by the battery temperature detection unit, and
the substrate processing apparatus includes:
a wafer cooling control unit that performs control to cool the temperature measurement wafer when the temperature data of the battery unit has a value equal to or more than a predetermined operation threshold; and
a notification unit that notifies that the temperature of the battery unit has a value equal to or more than the operation threshold.

11. The substrate processing system according to claim 7, wherein
the substrate processing apparatus includes
a temperature control unit that adjusts a temperature of the heating plate based on the temperature data of the heating plate transmitted from the transmission unit, and
the temperature control unit
adjusts the temperature of the heating plate based on the temperature data of the heating plate in a state where the temperature measurement wafer is placed on the heating plate.

12. A substrate processing system comprising a substrate processing apparatus that performs at least thermal processing on a substrate,
the substrate processing apparatus including:
a thermal processing unit including a heating plate that is the temperature measurement subject and performs heating processing on the substrate that has been mounted;
a standby unit including a holding unit that holds the temperature measurement wafer according to any one of claims 1 to 6, the standby unit being configured to allow the temperature measurement wafer held by the holding unit to wait inside the substrate processing apparatus;
a conveyance unit that conveys the temperature measurement wafer between the thermal processing unit and the standby unit; and
a power feeding unit that supplies power to the battery unit of the temperature measurement wafer conveyed to the standby unit.
